# EUROPEAN PATENT APPLICATION

(11) **EP 4 531 215 A1**
(43) Date of publication of application: **02.04.2025**
(21) Application number: 23896945.5
(22) Date of filing: 01.12.2023
(51) Int. Cl.: H01S 5/11, G02B 6/032

(54) **PHOTONIC CRYSTAL LASER AND PREPARATION METHOD THEREFOR**

(30) Priority: 02.12.2022 CN 202211532616
(71) Applicant: Shenzhen Photonx Technology Co., Ltd., Shenzhen, Guangdong 518129 (CN)
(72) Inventor: GU, Junyi, Shenzhen, Guangdong 518129 (CN); CHEN, Zihao, Shenzhen, Guangdong 518129 (CN); ZHU, Xiaoqi, Shenzhen, Guangdong 518129 (CN); PENG, Chao, Shenzhen, Guangdong 518129 (CN)
(74) Representative: Kraus & Lederer PartGmbB
(86) International application number: PCT/CN2023/135911
(87) International publication number: WO 2024/114803

(57) **Abstract**

A photonic crystal laser (10) and a preparation method therefor. The preparation method comprises: forming a first-type semiconductor doped layer film (S12); applying a corrosion inhibitor to the first-type semiconductor doped layer film, and performing a pre-curing treatment on same to form a corrosion inhibitor layer (S13); performing nanoimprinting on the corrosion inhibitor layer by using an imprinting template, transferring a pattern of the imprinting template onto the corrosion inhibitor layer, and performing a curing treatment on same to form a corrosion inhibitor layer pattern (S14); and implementing a patterning process on the first-type semiconductor doped layer film by taking the corrosion inhibitor layer pattern as a mask, so as to form a photonic crystal layer (S15). The photonic crystal layer comprises a photonic crystal portion (100), wherein the photonic crystal portion (100) comprises a plurality of through holes (101), which are arranged in an array, a central region (102), and a peripheral region (103). The plurality of through holes (101) comprise first through holes (101a), which are arranged in an array in the central region (102), and second through holes (101b), which are arranged in an array in the peripheral region (103), wherein the relative arrangement density of the first through holes (101a) is different from that of the second through holes (101b), and in the same direction, the range of the variance of a first distance (d1) between any two adjacent first through holes (101a) is 1 to 100 nm². The photonic crystal portion (100) is formed by using a nanoimprinting technique, thereby facilitating an improvement in the production efficiency and a reduction in the production cost.

## Description

This application claims the priority of the Chinese Patent Application No. 202211532616.4, which was filed on December 02, 2022, the disclosure of which is incorporated herein by reference in its entirety as part of the present application.

### TECHNICAL FIELD

Embodiments of the present disclosure relate to a photonic crystal laser and a preparing method of a photonic crystal laser.

### BACKGROUND

Photonic crystal is a material formed by arranging different media in a periodic or quasi-crystal structure. Two-dimensional photonic crystal is relatively easy to manufacture, and its two-dimensional structure can fully show the characteristics of photonic crystal, which has attracted extensive attention of researchers. The structure of usual photonic crystal layer is to form periodically arranged holes in a film with high dielectric constant, and fill the periodically arranged holes with a material with low dielectric constant to obtain a photonic crystal layer with periodically arranged holes.

Photonic crystal layer is an important part of a photonic crystal laser. Photonic crystal laser has many advantages, such as high power, strong reliability, long life, small volume, high quality factor, small divergence angle, narrow spectral line, suitable for multi-wavelength single-mode operation and low cost. It has high application value in laser pumping, medical treatment, communication and other fields.

### SUMMARY

At least one embodiment of the present disclosure provides a photonic crystal laser and a preparing method thereof. A photonic crystal part included in the photonic crystal laser is formed by nanoimprint technology, and the preparing method of the photonic crystal laser provided by the embodiment of the present disclosure is helpful to improve the production efficiency and reduce the production cost of the photonic crystal laser, and is of great significance to the industrial production of the photonic crystal laser.

At least one embodiment of the present disclosure provides a photonic crystal laser, the photonic crystal laser comprises: a photonic crystal part, in which the photonic crystal part comprises a plurality of through holes arranged in an array, the photonic crystal part comprises a central region and a peripheral region surrounding the central region, and the plurality of through holes comprise first through holes arranged in an array in the central region and second through holes arranged in an array in the peripheral region; a relative arrangement density of the first through holes is different from a relative arrangement density of the second through holes, and, in a same direction, a variance of first distances between any two adjacent ones of the first through holes ranges from 1 nm² to 100 nm².

For example, in the photonic crystal laser provided by at least one embodiment of the present disclosure, a minimum distance between any two adjacent ones of the first through holes is a second distance, and a minimum distance between any two adjacent ones of the second through holes is a third distance, and the relative arrangement density of the first through holes is larger than the relative arrangement density of the second through holes, and the second distance is smaller than the third distance; or, the relative arrangement density of the first through holes is smaller than the relative arrangement density of the second through holes, and the second distance is larger than the third distance.

For example, in the photonic crystal laser provided by at least one embodiment of the present disclosure, a minimum distance between any adjacent first through hole and second through hole is a fourth distance, the relative arrangement density of the first through holes is larger than the relative arrangement density of the second through holes, and the fourth distance is larger than the second distance and smaller than the third distance; or, the relative arrangement density of the first through holes is smaller than the relative arrangement density of the second through holes, and the fourth distance is larger than the third distance and smaller than the second distance.

For example, in the photonic crystal laser provided by at least one embodiment of the present disclosure, a transition region is further provided between the central region and the peripheral region, and the plurality of through holes further comprise third through holes arranged in an array in the transition region, and a minimum distance between any two adjacent ones of the third through holes is a fifth distance, and the relative arrangement density of the first through holes is larger than a relative arrangement density of the third through holes, and the relative arrangement density of the third through holes is larger than the relative arrangement density of the second through holes, the second distance is smaller than the fifth distance, and the fifth distance is smaller than the third distance; or, the relative arrangement density of the first through holes is smaller than the relative arrangement density of the third through holes, and the relative arrangement density of the third through holes is smaller than the relative arrangement density of the second through holes, the second distance is larger than the fifth distance, and the fifth distance is larger than the third distance.

For example, in the photonic crystal laser provided by at least one embodiment of the present disclosure, a minimum distance between adjacent third through hole and first through hole is a sixth distance, and a minimum distance between adjacent third through hole and second through hole is a seventh distance, the relative arrangement density of the first through holes is larger than the relative arrangement density of the third through holes, and the relative arrangement density of the third through holes is larger than the relative arrangement density of the second through holes, and the sixth distance is smaller than the fifth distance, and the fifth distance is smaller than the seventh distance; or, the relative arrangement density of the first through holes is smaller than relative arrangement density of the third through holes, and the relative arrangement density of the third through holes is smaller than relative arrangement density of the second through holes, and the sixth distance is larger than the fifth distance, and the fifth distance is larger than the seventh distance.

For example, in the photonic crystal laser provided by at least one embodiment of the present disclosure, each of the first through holes, each of the second through holes and each of the third through holes have a same plane shape and a same plane size.

For example, in the photonic crystal laser provided by at least one embodiment of the present disclosure, the first through holes are arranged in a matrix, an overall outline shape of the first through holes arranged in the matrix is a rectangle shape, and the second through holes are respectively arranged at sides of edges of the rectangle shape away from a center of the central region, and the second through holes surround a whole of the first through holes arranged in the matrix.

For example, in the photonic crystal laser provided by at least one embodiment of the present disclosure, the matrix with the rectangle shape formed by the first through holes is a square matrix, and a plane shape of the central region is square shape; the peripheral region comprises four edge regions and four corner regions, and shapes of the four edge regions and the four corner regions are all rectangular; a long edge of each of the four edge regions close to the central region is aligned with a corresponding edge of four edges of the central region respectively and has a same length with the corresponding edge; the four corner regions are respectively located in directions away from the center of the square shape at the four corners of the central region, and two adjacent edges of each of the four corner regions are respectively aligned with short edges, which are close to the two adjacent edges of each of the four corner regions, of two adjacent edge regions and have same length with the short edges of two adjacent edge regions.

For example, in the photonic crystal laser provided by at least one embodiment of the present disclosure, the four edge regions are all rectangular regions arranged by Na×Nb second through holes, and the four corner regions are all square regions arranged by Nb×Nb second through holes, and both Na and Nb are positive integers.

For example, the photonic crystal laser provided by at least one embodiment of the present disclosure, further comprises an active layer and a first dielectric layer arranged between the active layer and the photonic crystal part, in which the active layer is configured to emit light and serve as an optical gain medium.

For example, the photonic crystal laser provided by at least one embodiment of the present disclosure, further comprises a second dielectric layer arranged at a side of the photonic crystal part away from the first dielectric layer, in which each of the through holes comprises a first end and a second end which are opposite along an extending direction of a channel thereof, the first end is connected with the first dielectric layer, and the second end is connected with the second dielectric layer.

For example, the photonic crystal laser provided by at least one embodiment of the present disclosure, further comprises an n-type substrate; an n-type semiconductor heavily doped layer and an n-type semiconductor doped layer sequentially arranged on the n-type substrate; a p-type semiconductor doped layer and a p-type semiconductor heavily doped layer sequentially arranged at a side of the active layer away from the n-type substrate; a p-type electrode layer arranged at a side of the p-type semiconductor heavily doped layer away from the n-type substrate; and an n-type electrode layer arranged at a side of the n-type semiconductor heavily doped layer away from the n-type substrate and spaced apart from the n-type semiconductor doped layer; in which the active layer is arranged at a side of the n-type semiconductor doped layer away from the n-type substrate; the p-type semiconductor heavily doped layer is configured as the second dielectric layer; the p-type semiconductor doped layer is configured as the photonic crystal part and the first dielectric layer.

For example, the photonic crystal laser provided by at least one embodiment of the present disclosure, further comprises an n-type substrate; an n-type semiconductor heavily doped layer and an n-type semiconductor doped layer sequentially arranged on the n-type substrate; a p-type semiconductor doped layer and a p-type semiconductor heavily doped layer sequentially arranged at a side of the active layer away from the n-type substrate; a p-type electrode layer arranged at a side of the p-type semiconductor heavily doped layer away from the n-type substrate, and an n-type electrode layer arranged at a side of the n-type semiconductor heavily doped layer away from the n-type substrate and spaced apart from the n-type semiconductor doped layer; in which the active layer is arranged at a side of the n-type semiconductor doped layer away from the n-type substrate; the n-type semiconductor heavily doped layer is configured as the second dielectric layer; the n-type semiconductor doped layer is configured as the photonic crystal part and the first dielectric layer.

At least one embodiment of the present disclosure further provides a preparing method of a photonic crystal laser, and the preparing method comprises: providing a base substrate; forming a first type semiconductor doped layer film on the base substrate; applying a resist on the first type semiconductor doped layer film and pre-curing the resist to form a resist layer; nanoimprinting the resist layer with an imprint template to transfer a pattern of the imprint template to the resist layer, and curing the resist layer to form a resist layer pattern; patterning the first type semiconductor doped layer film with the resist layer pattern as a mask to form a photonic crystal layer, and removing the resist layer pattern; in which the photonic crystal layer comprises a plurality of through holes arranged in an array, and the photonic crystal layer comprises a central region and a peripheral region surrounding the central region, and the plurality of through holes comprise first through holes arranged in an array in the central region and second through holes arranged in an array in the peripheral region; a relative arrangement density of the first through holes is different from a relative arrangement density of the second through holes, and in a same direction, a variance of first distances between any two adjacent ones of the first through holes ranges from 1 nm² to 100 nm².

For example, the preparing method provided by at least one embodiment of the present disclosure, further comprises: forming an active layer film on the base substrate; forming a first dielectric layer film between the active layer film and the photonic crystal layer; in which the active layer film is configured to emit light and serve as an optical gain medium.

For example, the preparing method provided by at least one embodiment of the present disclosure, further comprises: forming a second dielectric layer film at a side of the photonic crystal layer away from the first dielectric layer film, in which a material of the second dielectric layer film is a first type semiconductor heavily doped material, and each of the through holes comprises a first end and a second end which are opposite along an extending direction of a channel thereof, the first end is connected with the first dielectric layer film, and the second end is connected with the second dielectric layer film.

For example, the preparing method provided by at least one embodiment of the present disclosure, further comprises: forming a second type semiconductor doped layer film on the base substrate, in which the second type semiconductor doped layer film and the active layer film are arranged on a same surface of the base substrate with the photonic crystal layer, and the active layer film is sandwiched between the photonic crystal layer and the second type semiconductor doped layer film.

For example, the preparing method provided by at least one embodiment of the present disclosure, further comprises: forming a second type semiconductor heavily doped layer film on a side of the second type semiconductor doped layer film away from the active layer film.

For example, in the preparing method provided by at least one embodiment of the present disclosure, the first type semiconductor doped layer film is a p-type semiconductor doped layer film, and the second type semiconductor doped layer film is an n-type semiconductor doped layer film; in a process of patterning the first type semiconductor doped layer film with the resist layer pattern as a mask to form the photonic crystal layer, the first dielectric layer film is further formed at a side of the photonic crystal layer close to the base substrate, and the photonic crystal layer and the first dielectric layer film are of an integrated structure.

For example, the preparing method provided by at least one embodiment of the present disclosure, further comprises: forming a hard mask at a side of the second dielectric film away from the base substrate, forming a photoresist layer at a side of the hard mask away from the base substrate, patterning the photoresist layer to form a photoresist pattern covering a preset region, patterning the hard mask with the photoresist pattern as a mask and removing the photoresist pattern to form a hard mask pattern, patterning the second dielectric layer film, the photonic crystal layer, the first dielectric layer film, the active layer film and the second type semiconductor doped layer film with the hard mask pattern as a mask to form the second dielectric layer, the photonic crystal part, the first dielectric layer, the active layer and the second type semiconductor doped layer respectively, and an edge of an orthographic projection of the second type semiconductor doped layer on the base substrate and an edge of an orthographic projection of the second type semiconductor heavily doped layer film on the base substrate have a gap therebetween.

For example, the preparing method provided by at least one embodiment of the present disclosure, further comprises: removing the hard mask pattern, forming a p-type electrode layer at a side of the second dielectric layer away from the base substrate, and forming an n-type electrode layer at a side of the second type semiconductor heavily doped layer film away from the base substrate in the gap.

For example, in the preparing method provided by at least one embodiment of the present disclosure, the first type semiconductor doped layer film is an n-type semiconductor doped layer film, and the second type semiconductor doped layer film is a p-type semiconductor doped layer film, the preparing method further comprises: forming a hard mask at a side of the second type semiconductor heavily doped layer film away from the base substrate, forming a photoresist layer at a side of the hard mask away from the base substrate, patterning the photoresist layer to form a photoresist pattern covering a preset region, patterning the hard mask with the photoresist pattern as a mask and removing the photoresist pattern to form a hard mask pattern, patterning the second type semiconductor heavily doped layer film, the second type semiconductor doped layer film, the active layer film, the first dielectric layer film and the photonic crystal layer film with the hard mask pattern as a mask to form the second type semiconductor heavily doped layer, the second type semiconductor doped layer, the active layer, the first dielectric layer and the photonic crystal part respectively, and an edge of an orthographic projection of the photonic crystal part on the base substrate and an edge of an orthographic projection of the second type semiconductor heavily doped layer film on the base substrate have a gap therebetween.

For example, the preparing method provided by at least one embodiment of the present disclosure, further comprises: removing the hard mask pattern, forming a p-type electrode layer at a side of the second type semiconductor heavily doped layer away from the base substrate, and forming an n-type electrode layer at a side of the second type semiconductor heavily doped layer film away from the base substrate in the gap.

### BRIEF DESCRIPTION OF DRAWINGS

In order to explain the technical solution of the embodiments of the present disclosure more clearly, the attached drawings of the embodiments of the present disclosure will be briefly introduced below. The attached drawings are only used to show some embodiments of the present disclosure, and are not limited to all embodiments of the present disclosure.
Fig. 1 is a block diagram of a photonic crystal laser according to at least one embodiment of the present disclosure;
Fig. 2 is a schematic plan view of a photonic crystal part provided by at least one embodiment of the present disclosure;
Fig. 3 is a schematic plan view of another photonic crystal part provided by at least one embodiment of the present disclosure;
Fig. 4 is a partially enlarged structural schematic diagram of a central region of the photonic crystal part in Fig. 2;
Fig. 5 is an enlarged structural schematic diagram of a dashed line defined area A in Fig. 2;
Fig. 6 is an enlarged structural schematic diagram of a dashed line defined area B in Fig. 3;
Fig. 7 is a schematic plan view of another photonic crystal part provided by at least one embodiment of the present disclosure;
Fig. 8 is an enlarged structural schematic diagram of a dashed line defined area C in Fig. 7;
Fig. 9 is a schematic plan view of another photonic crystal part provided by at least one embodiment of the present disclosure;
Fig. 10 is an enlarged structural schematic diagram of a dashed line defined area D in Fig. 9;
Fig. 11 is a schematic plan view of another photonic crystal part provided by at least one embodiment of the present disclosure;
Fig. 12 is a schematic cross-sectional structural diagram of a photonic crystal laser provided by at least one embodiment of the present disclosure;
Fig. 13 is a schematic cross-sectional structural diagram of another photonic crystal laser provided by at least one embodiment of the present disclosure;
Fig. 14 is a flowchart of a preparing method of a photonic crystal laser provided by at least one embodiment of the present disclosure;
Figs. 15A- 15E are process diagrams of a preparing method of a photonic crystal laser provided by at least one embodiment of the present disclosure;
Fig. 16 is a flowchart of another preparing method of a photonic crystal laser provided by at least one embodiment of the present disclosure;
Figs. 17A- 17H are process diagrams of a preparing method of a photonic crystal laser provided by at least one embodiment of the present disclosure;
Fig. 18 is a flowchart of another preparing method of a photonic crystal laser provided by at least one embodiment of the present disclosure; and
Figs. 19A- 19I are process diagrams of a preparing method of a photonic crystal laser provided by at least one embodiment of the present disclosure.

### DETAILED DESCRIPTION

In order to make the purpose, technical solution and advantages of the embodiments of the present disclosure more clear, the technical solution of the embodiments of the disclosure will be described clearly and completely with the attached drawings. Obviously, the described embodiments are a part of the embodiments of the present disclosure, not the whole embodiments. Based on the described embodiments of the present disclosure, all other embodiments obtained by ordinary skilled in the art without creative labor belong to the scope of protection of the present disclosure.

Unless otherwise defined, technical terms or scientific terms used here shall have their ordinary meanings as understood by people with ordinary skills in the field to which this present disclosure belongs. The "first", "second" and similar words used in the specification and claims of the present disclosure patent application do not indicate any order, quantity or importance, but are only used to distinguish different components. Similar words such as "including" or "containing" mean that the elements or objects appearing before the word cover the elements or objects listed after the word and their equivalents, without excluding other elements or objects. Similar words such as "connecting" or "connected" are not limited to physical or mechanical connection, but can include electrical connection, whether direct or indirect. "Up", "Down", "Left" and "Right" are only used to indicate the relative positional relationship. When the absolute position of the described object changes, the relative positional relationship may also change accordingly.

Photonic crystal laser has many advantages, such as high power, strong reliability, long life, small volume, high quality factor, small divergence angle, narrow spectral line width, suitable for multi-wavelength single-mode operation and low cost, and it has many applications in various fields. The inventor(s) of the present disclosure has found that the current photonic crystal lasers generally have the problems of high excitation threshold and low peak power, mainly due to insufficient optimization of carrier distribution and small optical confinement factor, and the current photonic crystal lasers are mainly prepared and formed by electron beam lithography (EBL). However, there are some problems in the production mode of electron beam lithography, such as high preparation cost, high equipment cost and low production efficiency. Therefore, on the basis of balancing robustness and quality factor (Q value), nanoimprint technology can be considered to prepare photonic crystal layer, so as to reduce the production cost and improve the production efficiency of the photonic crystal laser, and make this preparing method suitable for large-scale production of photonic crystal laser.

It should be noted that the robustness of the photonic crystal laser refers to that photonic crystal laser has the ability to keep certain performance unchanged under the disturbance of uncertainty. Quality factor (Q value) is an index to evaluate the quality of optical resonator in lasers (including photonic crystal lasers). Q value is defined as a ratio of the total energy stored in the laser resonant cavity to the energy lost per unit time in the resonant cavity. Q=2πvW/(dw/dt), where W is the total energy stored in the resonant cavity, dw/dt is a loss rate of photon energy, that is, the energy lost per unit time, and *v* is the center frequency of laser.

For example, at least one embodiment of the present disclosure provides a photonic crystal laser. The photonic crystal laser includes a photonic crystal part including a plurality of through holes arranged in an array, the photonic crystal part includes a central region and a peripheral region surrounding the central region, and the plurality of through holes include first through holes arranged in an array in the central region and second through holes arranged in an array in the peripheral region, and a relative arrangement density of the first through holes is different from a relative arrangement density of the second through holes; in a same direction, the variance of first distances between any two adjacent first through holes ranges from 1 nm² to 100 nm², that is, the first distances between two adjacent first through holes in the central region of the photonic crystal part prepared by nanoimprint method in the embodiments of the present disclosure fluctuates. Moreover, the variance of the first distances between any two adjacent first through holes is within the above range, so that on the basis of ensuring high robustness, high quality factor (Q value) and the like, the photonic crystal part can be prepared by adopting nanoimprint technology, so that the production cost is reduced and the production efficiency is improved, and it is suitable for large-scale production, so that it is unnecessary to adopt electron beam lithography to produce the photonic crystal part with the variance of the first distances larger than 0 nm² and smaller than 1 nm². In addition, the method of electron beam lithography greatly reduces the production efficiency, increases the production cost, and does not guarantee the robustness. The quality factor of the photonic crystal part prepared by the electron beam lithography method is not obviously improved compared with the photonic crystal part prepared by the nanoimprint technology. Therefore, the production efficiency can be improved on the basis of ensuring the performance by comprehensively considering to utilizing the nanoimprint technology to prepare the photonic crystal part included in the photonic crystal laser.

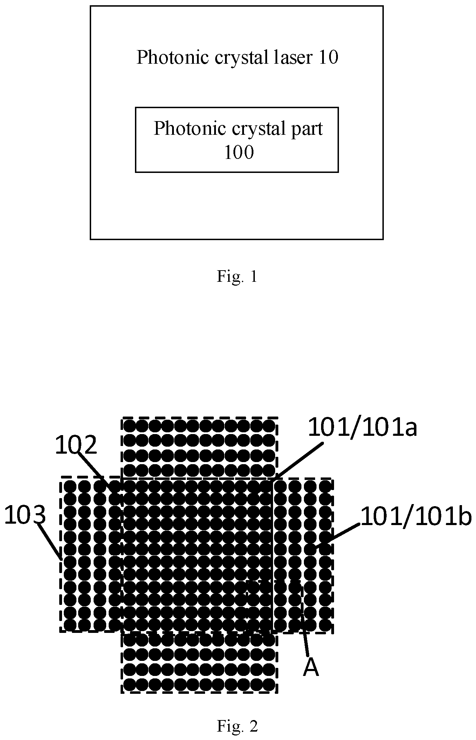

For example, Fig. 1 is a block diagram of a photonic crystal laser according to at least one embodiment of the present disclosure. As illustrated by Fig. 1, the photonic crystal laser 10 includes a photonic crystal part 100. The working principle of the photonic crystal part 100 is that the photonic band gap structure is generated in the photonic crystal part due to the periodic change of the refractive index of light, so that the movement of light in the photonic crystal part is controlled by the photonic band gap structure, that is, the photonic crystal part periodically appears low refractive index at some positions of high refractive index material. The photonic crystal bandgap (similar to the forbidden band in semiconductor) can be generated by alternately arranging material with high refractive index and material with low refractive index, and the distance between periodically arranged low refractive index sites is the same, which leads to the band effect of photonic crystal with a certain distance only on light waves with a certain frequency, that is to say, only light with a certain frequency will be completely prohibited from propagating in a photonic crystal with a certain periodic distance.

For example, Fig. 2 is a schematic plan view of a photonic crystal part provided by at least one embodiment of the present disclosure. As illustrated by Fig. 2, the photonic crystal part 100 includes a plurality of through holes 101 arranged in an array. As illustrated by Fig. 2, the plurality of through holes 101 are arranged in an array, and in Fig. 2, the plane shape of each through hole 101 is taken as a circle as an example. In Fig. 2, diameters of the circles are equal, that is, the plane sizes of the through holes 101 are equal. Of course, the embodiments of the present disclosure are not limited thereto, and the plane shape of each of the through holes 101 can also be an ellipse, a triangle, a regular hexagon, an irregular pattern or a combination of multiple patterns, and the embodiments of the present disclosure are not limited thereto, as long as the through holes 101 are arranged in an array and can be easily formed by nanoimprinting.

It should be noted that, in the case that a plane shape of the through hole 101 is a circular shape, a pattern that can be imprinted by the imprinting template used in the nanoimprinting process is a circular shape; in the case that a plane shape of the through hole 101 is a triangular shape, the pattern that can be imprinted by the imprint template used in the nanoimprint process is a triangular shape; in the case that the plane shape of the through hole 101 is an elliptical shape, the pattern that can be imprinted by the imprinting template used in the nanoimprinting process is an elliptical shape; in the case that the plane shape of the through hole 101 is a regular hexagon, the pattern that can be imprinted by the imprint template used in the nanoimprint process is a regular hexagon, that is, according to the different plane shapes of the formed through holes 101, the shapes of the patterns that can be imprinted by the selected nanoimprint template are different. For example, in the same photonic crystal part, a part of the through holes 101 and another part of the through holes 101 may also have different plane shapes or different plane sizes. In the embodiments of the present disclosure, it is only needed to select an appropriate nanoimprint template according to the patterns of the through holes to be formed, and there are many kinds of nanoimprint templates, which can easily meet the requirements of different patterns. The cost of the nanoimprinting template is low, and the photonic crystal part provided with through holes with different plane shapes or different plane sizes is only formed in one imprinting process, and other process conditions remain unchanged. However, for the commonly used electron beam lithography process, the lithography takes a long time, which will reduce the work efficiency and increase the production cost.

For example, in Fig. 2, the shape of each of the through holes 101 is a cylindrical shape, the plane shape of each of the through holes 101 is a circular shape, and the diameters of the circular shapes are the same. In one example, along the respective extending direction of each of the through holes 101, the size of each of the through holes 101 is equal or approximately equal. The following description mainly takes the case that the plane shape of the through hole 101 is a circular shape as an example.

For example, in other examples, the shape of the through hole 101 can also be an elliptical cylinder, that is, the plane shapes of the through holes 101 are elliptical shapes, and the major axes of the elliptical shapes are equal, and the short axes of the elliptical shapes are equal; the shape of the through hole 101 can also be a triangular prism, that is, the plane shapes of the through holes 101 are triangular shapes, and the three edges of any two triangular shapes are respectively equal. Of course, in other embodiments, the through holes 101 may have other shapes, which is not limited by the embodiments of the present disclosure.

For example, as illustrated by Fig. 2, the photonic crystal part 100 includes a central region 102 and a peripheral region 103 surrounding the central region 102. For example, in Fig. 2, the case that the plan shapes of the central region 102 and the peripheral region 103 are both rectangular shapes are described as an example, and the through holes 101 in the peripheral region 103 only surround four edge regions of the through holes 101 located in the central region 102, but does not surround corner regions. Of course, the embodiments of the present disclosure are not limited thereto, and the central region 102 may be surrounded at the corner region, or the overall shape of the peripheral region 103 may not be a plurality of rectangles, but may be a circular ring, a square ring, an elliptical ring, etc., as long as the energy of the central region 102 of the photonic crystal part can be suppressed from leaking from the peripheral region 103 or the energy of the central region 102 of the photonic crystal part can be controlled to radiate to the peripheral region 103.

For example, as illustrated by Fig. 2, the plurality of through holes 101 include first through holes 101a arranged in an array in the central region 102 and second through holes 101b arranged in an array in the peripheral region 103. A relative arrangement density of the first through holes 101a is different from a relative arrangement density of the second through holes 101b. Specifically, in Fig. 2, the relative arrangement density of the first through holes 101a is larger than the relative arrangement density of the second through holes 101b. For example, in Fig. 2, in the same direction, the variance of first distances d1 between any two adjacent first through holes 101a ranges from 1 nm² to 100 nm². That is, the first distances d1 between two adjacent first through holes 101a in the central region of the photonic crystal part prepared by nanoimprint method in the embodiments of the present disclosure fluctuates, and the variance of the first distances d1 between any two adjacent first through holes 101a is within the above range, so that the photonic crystal part can be prepared by nanoimprint technology on the basis of ensuring high robustness and high quality factor (Q value), so as to reduce the production cost and improve the production efficiency, and is suitable for large-scale production, so that it is not necessary to adopt electron beam lithography to produce the photonic crystal part with the variance of the first distances larger than 0 nm² and smaller than 1 nm², thus greatly reducing the production efficiency and improving the production cost, and the electron beam lithography cannot guarantee the robustness and quality factor to be obviously improved compared with the photonic crystal part prepared by nanoimprint technology.

It should be noted that variance refers to the average of the square value of the difference between each sample value and the average of all sample values, which is used to measure the degree of dispersion.

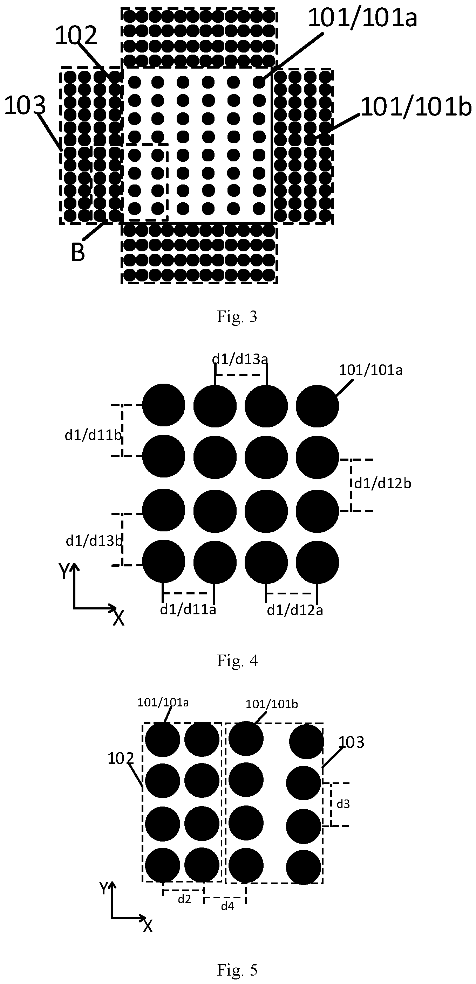

For example, Fig. 3 is a schematic plan view of another photonic crystal part provided by at least one embodiment of the present disclosure. As illustrated by Fig. 3, the photonic crystal part 100 includes a central region 102 and a peripheral region 103 surrounding the central region 102. For example, in Fig. 3, the plan shapes of the central region 102 and the peripheral region 103 are both rectangular shapes, and the through holes 101 in the peripheral region 103 only surround the four edge regions of the through holes 101 located in the central region 102, but does not surround the corner regions. Of course, the embodiments of the present disclosure are not limited thereto, and the central region may be surrounded at the corner region, or the overall shape of the peripheral region may not be a plurality of rectangles, but may be a circular ring, a square ring, an elliptical ring, etc., as long as the energy of the central region 102 of the photonic crystal part can be suppressed from leaking from the peripheral region 103 or the energy of the central region 102 of the photonic crystal part can be controlled to radiate to the peripheral region 103.

For example, as illustrated by Fig. 3, the plurality of through holes 101 include first through holes 101a arranged in an array in the central region 102 and second through holes 101b arranged in an array in the peripheral region 103. In Fig. 3, the relative arrangement density of the first through holes 101a is smaller than the relative arrangement density of the second through holes 101b. For example, in Fig. 3, in the same direction, the variance of the first distances d1 between any two adjacent first through holes 101a ranges from 1 nm² to 100 nm².

It should be noted that the variance of the first distances d1 between any two adjacent first through holes 101a can range from 1 nm² to 10 nm², 15 nm² to 20 nm², 25 nm² to 29 nm², 30 nm² to 35 nm², 36 nm² to 42 nm², 45 nm² to 50 nm², 51 nm² to 65 nm², 66 nm² to 72 nm², 73 nm² to 80 nm², 81 nm² to 88 nm², 89 nm² to 95 nm², or 96 nm² to 100 nm², etc. Embodiments of the present disclosure are not limited thereto.

It should be noted that when the plane shapes and dimensions of the first through holes 101a and the second through holes 101b are the same, the relative arrangement density of the first through holes 101a refers to the number of the first through holes 101a per unit area, and the relative arrangement density of the second through holes 101b refers to the number of the second through holes 101b per unit area. In the case that the shapes or sizes of the first through holes 101a and the second through holes 101b are different, equivalent conversion is performed according to the plane areas of the first through holes 101a and the second through holes 101b. For example, in the case that the plane area of one first through hole 101a is equivalent to the plane areas of two second through holes 101b, the relative arrangement density of the first through holes 101a refers to twice the number of the first through holes 101a in a unit area. The relative arrangement density of the second through holes 101b refers to the number of the second through holes 101b per unit area, or in the case that the plane area of one first through hole 101a is equivalent to the plane area of 0.5 of one of the second through holes 101b, the relative arrangement density of the first through holes 101a refers to the number of the first through holes 101a per unit area, and the relative arrangement density of the second through holes 101b refers to twice that of the second through holes 101b per unit area. That is, in the case that the plane area of a first through hole 101a is equivalent to the plane area of n second through holes 101b, and n is larger than 1, the relative arrangement density of the first through holes 101a refers to n times the number of the first through holes 101a per unit area, and the relative arrangement density of the second through holes 101b refers to the number of the second through holes 101b per unit area; in the case that n is larger than 0 and smaller than 1, and the plane area of one first through hole 101a is equivalent to the plane area of n second through holes 101b, the relative arrangement density of the first through holes 101a refers to the number of the first through holes 101a in unit area, and the relative arrangement density of the second through holes 101b refers to 1/n times the number of the second through holes 101b in unit area.

For example, in one example, the relative arrangement density of the whole of the first through holes 101a is different from the relative arrangement density of the whole of the second through holes 101b, and the relative arrangement density per unit area of the first through holes 101a and the relative arrangement density of the whole of the second through holes 101b are also different.

For example, in one example, although the relative arrangement densities of the first through holes 101a and the second through holes 101b in Fig. 3 are different, the first through holes 101a and the second through holes 101b in Fig. 3 can also be completed in the same nanoimprint process step; although the relative arrangement densities of the first through holes 101a and the second through holes 101b in Fig. 4 are different, the first through holes 101a and the second through holes 101b in Fig. 4 can also be completed in the same nanoimprint process step, and the preparation of the first through holes 101a and the second through holes 101b in Fig. 3 and Fig. 4 will not increase the process steps or the production cost.

For example, Fig. 4 is a partially enlarged structural schematic diagram of a central region of the photonic crystal part in Fig. 2, as illustrated by Fig. 4, the first through holes 101a are formed by nanoimprinting, the first through holes 101a are arranged in a matrix, that is, the first through holes 101a are arranged in the X-axis direction and the Y-axis direction respectively, and a plane defined by the X-axis and the Y-axis is the plane where the top surfaces of the first through holes 101a are located, and a direction perpendicular to the plane defined by the X-axis and the Y-axis is a thickness direction of the photonic crystal laser, which is also the extending direction of the through holes.

For example, as illustrated by Fig. 4, in the same direction, there are first distances d1 between any two adjacent first through holes 101a, and the first distances d1 can fluctuate within a certain range. For example, in the case that the X-axis direction is the first direction, the distances between two adjacent first through holes 101a in the first direction can be d11a, d12a and d13a, respectively, and the formula for calculating the variance D1a of the first distances d1 is: D1a = [(d11a-d1a') ²+(d12a-d1a') ²+(d13a-d1a')²]/3, where d1a' is an average of d11a, d12a and d13a. If there are n first distances d1 in the first direction and n is a natural number larger than or equal to 1, the formula for calculating the variance D1a of the first distances d1 is: D1a =[(d11a-d1a') ²+(d12a-d1a') ²+(d13a-d1a')²···+ (d1na-d1a')²]/n, where d1a' is an average of d11a, d12a ... d1na. In the case that the Y-axis direction is the second direction, the distances between two adjacent first through holes 101a in the second direction can be d11b, d12b and d13b, respectively, and the formula for calculating the variance D1b of the first distances d1 is: D1b = [(d11b-d1b')²+(d12b-d1b')²+(d13b-d1b')²]/3, where d1b' is the average of d11b, d12b and d13b. If there are n first distances d1 in the first direction and n is a natural number larger than or equal to 1, the formula for calculating the variance D1b of the first distances d1 is: D1b=[ (d11b-d1b')2+(d12b-d1b')2+(d13b-d1b')²···+(d1nb-d1b')²]/n, where d1b' is the average of d11b, d12b ... d1nb. The values of D1a and D1b can be different, and the value of the variance is in a range.

For example, in other examples, in the case that the shape of the through hole is an elliptical column, that is, the plane shapes of the through holes 101 are elliptical shapes, the first distance d1 is the distance between the centers of two elliptical shapes adjacent in the same direction; in the case that the shape of the through hole is a triangular prism, that is, the plane shapes of the through holes 101 are triangular shapes, and the first distance d1 is the distance between the gravity centers of two adjacent triangles in the same direction, then the variance of the first distances d1 in the same direction is calculated based on the above formula.

For example, Fig. 5 is an enlarged structural schematic diagram of a dashed line defined area A in Fig. 2, the dashed line defined area A includes the first through holes 101a and the second through holes 101b. As illustrated by Fig. 5, the minimum distance between any two adjacent first through holes 101a is a second distance d2. It should be noted that the minimum distance between any two adjacent first through holes 101a refers to that any two adjacent first through holes 101a have different distances in different directions, and the minimum distance among these different distances is the minimum distance between any two adjacent first through holes 101a. In Fig. 5, the distance between two adjacent first through holes 101a in the first direction X is smaller than the distance between two adjacent first through holes 101a in the second direction Y, that is, the minimum distance between two adjacent first through holes 101a in the first direction X is d2.

For example, in Fig. 5, the minimum distance between any two adjacent second through holes 101b is a third distance d3. Similarly, the minimum distance between any two adjacent second through holes 101b refers to that any two adjacent second through holes 101b have different distances in different directions, and the minimum distance among these different distances is the minimum distance between any two adjacent second through holes 101b. In Fig. 5, the distance between two adjacent second through holes 101b in the second direction Y is smaller than the distance between two adjacent second through holes 101b in the first direction X, that is, the minimum distance between two adjacent second through holes 101b in the second direction Y is d3, and in Fig. 5, the relative arrangement density of the first through holes 101a is larger than the relative arrangement density of the second through holes 101b, and the second distance d2 is smaller than the third distance d3.

For example, in Fig. 5, a row of first through holes 101a close to the right side in the left dotted line frame and a row of second through holes 101b close to the left side in the right dotted line frame in Fig. 5 are respectively arranged adjacently, and the minimum distance between any adjacent first through hole 101a and second through hole 101b is a fourth distance d4, and the fourth distance d4 is larger than the second distance d2 and smaller than the third distance d3, that is, along the direction from the peripheral region 103 to the central region 102, the minimum distance between adjacent first through holes 101a, the minimum distance between adjacent first through hole 101a and second through hole 101b, and the minimum distance between adjacent second through holes 101b gradually decrease.

It should be noted that in another variation of Fig. 5, in the first direction X, along the direction from the peripheral region 103 to the central region 102, the distances between adjacent first through holes 101a gradually decrease, and the distances between adjacent second through holes 101b also gradually decrease, so that in the first direction X, along the direction from the peripheral region 103 to the central region 102, the distances between adjacent through holes 101 (including the first through holes 101a and the second through holes 101b) gradually decrease.

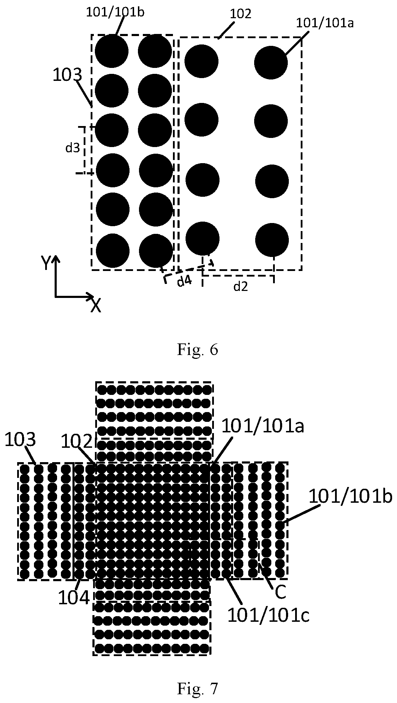

For example, Fig. 6 is an enlarged structural schematic diagram of a dashed line defined area B in Fig. 3, the dashed line defined area B includes first through holes 101a and second through holes 101b. As illustrated by Fig. 6, the minimum distance between any two adjacent first through holes 101a is a second distance d2. It should be noted that the minimum distance between any two adjacent first through holes 101a refers to that any two adjacent first through holes 101a have different distances in different directions, and the minimum distance among these different distances is the minimum distance between any two adjacent first through holes 101a. In Fig. 6, the distance between two adjacent first through holes 101a in the first direction X is smaller than the distance between two adjacent first through holes 101a in the second direction Y, that is, the minimum distance between two adjacent first through holes 101a in the first direction X is d2.

For example, in Fig. 6, the minimum distance between any two adjacent second through holes 101b is the third distance d3. Similarly, the minimum distance between any two adjacent second through holes 101b refers to that any two adjacent second through holes 101b have different distances in different directions, and the minimum distance among these different distances is the minimum distance between any two adjacent second through holes 101b. In Fig. 6, the distance between two adjacent second through holes 101b in the second direction Y is smaller than the distance between two adjacent second through holes 101b in the first direction X, that is, the minimum distance between two adjacent second through holes 101b in the second direction Y is d3, and in Fig. 6, the relative arrangement density of the first through holes 101a is smaller than the relative arrangement density of the second through holes 101b, and the second distance d2 is larger than the third distance d3.

For example, in Fig. 6, a row of second through holes 101b close to the right side in the left dotted line frame and a row of first through holes 101a close to the left side in the right dotted line frame in Fig. 6 are respectively arranged adjacently, and the minimum distance between any adjacent first through hole 101a and second through hole 101b is a fourth distance d4, and the fourth distance d4 is larger than the third distance d3 and smaller than the second distance d2.

For example, in Fig. 6, the second distance d2 is a distance in the first direction X, the third distance d3 is a distance in the second direction Y, and the fourth distance d4 is a distance in a direction with a certain angle to both the first direction and the second direction in the plane formed by the first direction X and the second direction Y, and the direct is determined according to the arrangement of the adjacent first through hole 101a and the second through hole 101b.

It should be noted that in another variation of Fig. 6, in the first direction X, along the direction from the peripheral region 103 to the central region 102, the distances between adjacent first through holes 101a gradually increase, and the distances between adjacent second through holes 101b also gradually increase. Except that the distances between adjacent first through holes 101a and second through holes 101b are not along the direction from the peripheral region 103 to the central region 102, the other distances between adjacent through holes 101 can be the distances along the direction from the peripheral region 103 to the central region 102 in the first direction X, that is, in Fig. 6, except the distances between adjacent first through holes 101a and second through holes 101b, in the direction from the peripheral region 103 to the central region 102, the other distances between adjacent through holes 101 can gradually increase.

For example, Fig. 7 is a schematic plan view of another photonic crystal part provided by at least one embodiment of the present disclosure. As illustrated by Fig. 7, the photonic crystal part 100 includes a central region 102, a peripheral region 103 surrounding the central region 102, and a transition region 104 between the central region 102 and the peripheral region 103. For example, in Fig. 7, the case that the plane shapes of the central region 102, the transition region 104 and the peripheral region 103 are all rectangular shapes is described as an example, and the through holes 101 in the peripheral region 103 only surrounds the four edge regions of the through holes located in the central region 102, but does not surround the corner regions. Of course, the embodiments of the present disclosure are not limited thereto, and the central region may be surrounded at the corner regions.

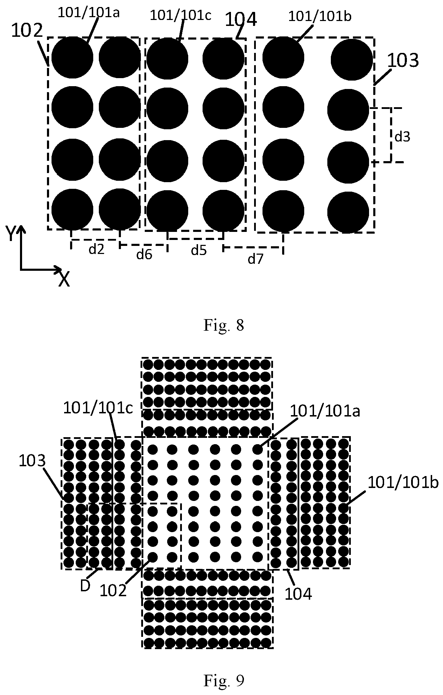

For example, Fig. 8 is an enlarged structural schematic diagram of a dashed line defined area C in Fig. 7. Combining with Fig. 7 and Fig. 8, the through holes 101 also include third through holes 101c arranged in an array in the transition region 104, the minimum distance between any two adjacent third through holes 101c is a fifth distance d5, the minimum distance between any two adjacent first through holes 101a is the second distance d2, and the minimum distance between any two adjacent second through holes 101b is the third distance d3. For example, in Fig. 7 and Fig. 8, the relative arrangement density of the first through holes 101a is larger than the relative arrangement density of the second through holes 101b, the relative arrangement density of the third through holes 101c is larger than the relative arrangement density of the second through holes 101b and smaller than the relative arrangement density of the first through holes 101a, and the second distance d2 is smaller than the fifth distance d5 and the fifth distance d5 is smaller than the third distance d3.

For example, as illustrated by Fig. 8, the minimum distance between adjacent third through hole 101c and first through hole 101a is a sixth distance d6, and the minimum distance between adjacent third through hole 101c and second through hole 101b is a seventh distance d7, the sixth distance d6 is smaller than the fifth distance d5 and larger than the second distance d2, the seventh distance d7 is larger than the fifth distance d5, and smaller than the third distance d3. This arrangement can make the peripheral region and the transition region fully surround the central region, and the periodicity of the third through holes 101c in the transition region arranged in the middle is different from the periodicity of the second through holes 101b in the peripheral region and the periodicity of the first through holes 101a in the central region 102, so that the transition region further blocks the energy leakage or radiation in the two-dimensional photonic crystal microcavity, so as to more fully inhibit the energy in the two-dimensional photonic crystal microcavity from leaking from the peripheral region or control the energy in the two-dimensional photonic crystal microcavity to radiate to the peripheral region, and moreover, the arrangement can also improve the robustness.

For example, Fig. 9 is a schematic plan view of another photonic crystal part provided by at least one embodiment of the present disclosure. As illustrated by Fig. 9, the photonic crystal part 100 includes a central region 102, a peripheral region 103 surrounding the central region 102, and a transition region 104 between the central region 102 and the peripheral region 103. For example, in Fig. 9, the plane shapes of the central region 102, the transition region 104 and the peripheral region 103 are all rectangular shapes, and the through holes 101 in the peripheral region 103 only surround the four edge regions of the through holes located in the central region 102, but do not surround the corner regions. Of course, the embodiments of the present disclosure are not limited thereto, and the central region may be surrounded at the corner regions.

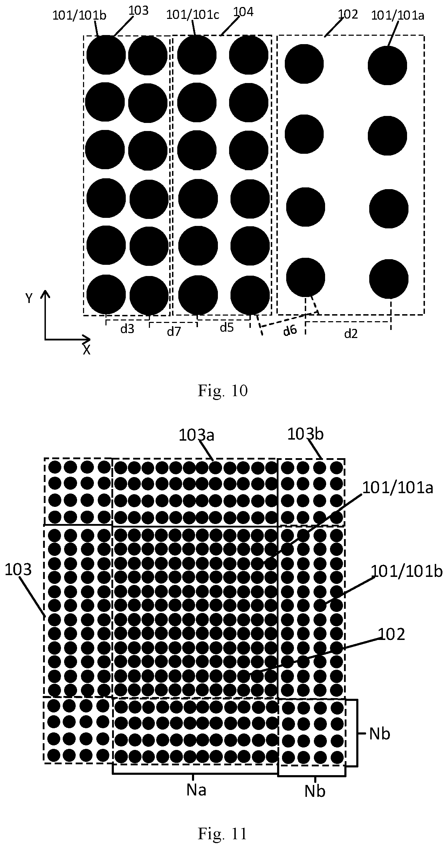

For example, Fig. 10 is an enlarged structural schematic diagram of a dashed line defined area D in Fig. 9. As illustrated by combination with Fig. 9 and Fig. 10, the through holes 101 also include third through holes 101c arranged in an array in the transition region 104, the minimum distance between any two adjacent third through holes 101c is a fifth distance d5, the minimum distance between any two adjacent first through holes 101a is the second distance d2, and the minimum distance between any two adjacent second through holes 101b is the third distance d3. For example, in Fig. 9 and Fig. 10, the relative arrangement density of the first through holes 101a is smaller than the relative arrangement density of the second through holes 101b, the relative arrangement density of the third through holes 101c is smaller than the relative arrangement density of the second through holes 101b and larger than the relative arrangement density of the first through holes 101a, the second distance d2 is larger than the fifth distance d5, and the fifth distance d5 is larger than the third distance d3.

For example, as illustrated by Fig. 10, the minimum distance between adjacent third through hole 101c and first through hole 101a is a sixth distance d6, and the minimum distance between adjacent third through hole 101c and second through hole 101b is a seventh distance d7, the sixth distance d6 is larger than the fifth distance d5 and smaller than the second distance d2, and the seventh distance d7 is smaller than the fifth distance d5 and larger than the third distance d3.

For example, in Fig. 10, the second distance d2, the third distance d3, the fifth distance d5 and the seventh distance d7 are all distances in the first direction X, and the sixth distance d6 is a distance in a direction which has a certain angle with both the first direction X and the second direction Y in the plane formed by the first direction X and the second direction Y, and the direction is determined according to the arrangement of the adjacent third through holes 101c and the first through holes 101a.

For example, in the structures shown in Fig. 7, Fig. 8, Fig. 9 and Fig. 10, the first through hole 101a, the second through hole 101b and the third through hole 101c have the same plane shapes and the same plane sizes. In Fig. 7, Fig. 8, Fig. 9 and Fig. 10, the case that the shape of the through hole 101 is a cylinder and the plane shape is a circular shape is described as an example. For the through holes 101 with other shapes or sizes, the abovementioned distances can be set according to the above relevant description, and the repeated descriptions are omitted herein.

For example, Fig. 11 is a schematic plan view of another photonic crystal part provided by at least one embodiment of the present disclosure. As illustrated by Fig. 11, the first through holes 101a are arranged in a matrix, and an overall outline shape of the first through holes 101a arranged in the matrix is a rectangle shape, and the second through holes 101b are respectively arranged at sides of edges of the rectangle shape away from a center of the central region 102, and surround a whole of the first through holes 101a arranged in the matrix. Therefore, the periphery of the matrix formed by the first through holes 101a is surrounded by the second through holes 101b, which can more fully inhibit the energy in the two-dimensional photonic crystal microcavity from leaking from the peripheral region 103 or control the energy in the two-dimensional photonic crystal microcavity to radiate to the peripheral region 103.

For example, as illustrated by Fig. 11, the matrix formed by the first through holes 101a is a square matrix, and the plane shape of the central region 102 is a square shape; the peripheral region 103 includes four edge regions 103a and four corner regions 103b, shapes of the four edge regions 103a and the four corner regions 103b are all rectangular shapes; a long edge of each of the four edge regions 103a close to the central region 102 is aligned with a corresponding edge of the four edges of the central region 102 and have the same length with the corresponding edge. The four corner regions 103b are respectively located in directions away from the center of the square shape at the four corners of the central region 102, and the two adjacent edges of each of the four corner regions 103b are respectively aligned with the short edges of the two adjacent edge regions 103a and have the same length with the short edges of two adjacent edge regions.

For example, as illustrated by Fig. 11, the four edge regions 103a are all rectangular regions arranged by Na×Nb second through holes 101b, and the four corner regions 103b are all rectangular regions arranged by Nb×Nb second through holes 101b, where both Na and Nb are positive integers, and Na is larger than Nb. For example, in Fig. 11, Na is 12, Nb is 4, the central region 102 includes 12*12 first through holes 101a, the edge region 103a includes 12*4 second through holes 101b, and the corner region 103b includes 4*4 second through holes 101b. Of course, the embodiments of the present disclosure are not limited thereto, and Na and Nb can also be other values. Na may be smaller than Nb, or Na is equal to Nb.

It should be noted that the size of the first through hole 101a in the central region 102, the distance between two adjacent first through holes 101a, and the value of Na can all be changed. The sizes and numbers of the second through holes 103b in the four edge regions 103a and the four corner regions 103b and the distances between adjacent second through holes 103b can be adjusted. By adjusting the above features in the edge regions 103a and the corner regions 103b, it is possible to suppress the energy in the microcavity included in the photonic crystal laser from leaking from the edge regions 103a and the corner regions 103b or control the energy in the microcavity included in the photonic crystal laser to irradiate to the edge regions 103a and the corner regions 103b.

For example, in one example, by adjusting at least one of the distance between the adjacent second through holes 103b in the edge regions 103a and the corner region 103b, the size of the second through holes 103b in the peripheral region, and intervals between the central region 102 and the edge regions 103a and the corner regions 103b, a band gap of the microcavity included in the photonic crystal laser can be formed, so that the energy can be confined in the central region 102 and the lateral energy of the microcavity can be suppressed.

For example, in one example, the leakage of energy in the microcavity included in the photonic crystal laser can be controlled by independently adjusting the sizes of the second through holes 103b in the edge region 103a and the corner region 103b corresponding to any direction of the edge and/or the distance between the adjacent second through holes 103b, so that the energy in the microcavity included in the photonic crystal laser can be radiated to any direction of the edge.

For example, in one example, by independently adjusting the number of the second through holes 103b in the edge region 103a and the corner region 103b corresponding to any direction of the edge, such as removing a part of the second through holes 103b, the leakage of energy in the microcavity included in the photonic crystal laser in this direction can be controlled, so that the energy of the microcavity included in the photonic crystal laser can be radiated to any direction of the edge.

For example, the structural design of the photonic crystal part 100 in the embodiments of the present disclosure can suppress the energy radiation on the upper and lower surfaces of the photonic crystal part 100 and the leakage of the edge energy, and confine the energy in the microcavity included in the photonic crystal laser, so as to improve the quality factor Q of the photonic crystal laser. At the same time, the energy can be controlled to radiate in any direction by destroying a part of the energy suppression conditions of the microcavity included in the photonic crystal laser, so as to realize the energy coupling between the energy in the microcavity included in the photonic crystal laser and the optical structure outside the microcavity.

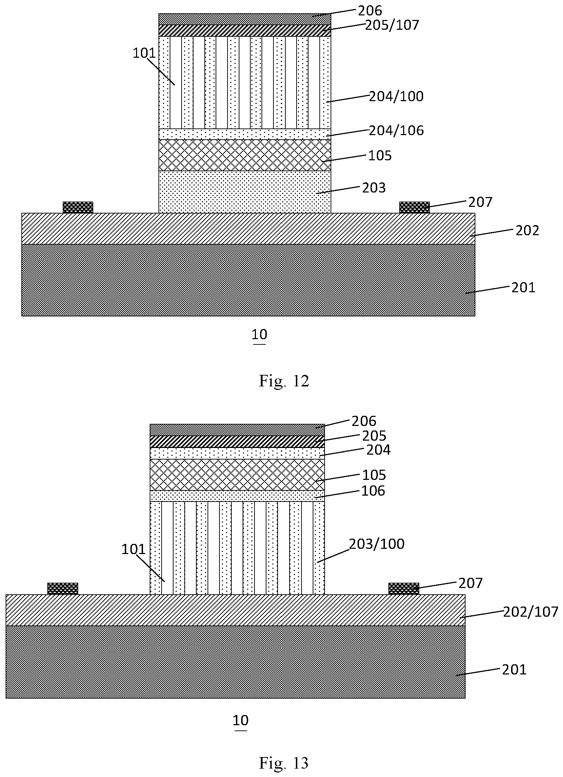

For example, Fig. 12 is a schematic cross-sectional structural diagram of a photonic crystal laser provided by at least one embodiment of the present disclosure. As illustrated by Fig. 12, the photonic crystal laser 10 further includes an active layer 105 and a first dielectric layer 106 arranged between the active layer 105 and the photonic crystal part 100. For example, the active layer 105 is configured to emit light and serve as a light gain medium, and the material of the active layer 105 includes a fluorescent material.

For example, as illustrated by Fig. 12, the photonic crystal laser 10 further includes a second dielectric layer 107 arranged at a side of the photonic crystal part 100 away from the first dielectric layer 106, each of the through holes 101 (including the first through holes 101a and the second through holes 101b) includes a first end 1011 and a second end 1012 which are opposite along an extending direction of a channel thereof, and the first end 1011 is connected with the first dielectric layer 106, and the second end 1012 is connected with the second dielectric layer 107. That is, the first dielectric layer 106 and the second dielectric layer 107 enclose the through hole 101. The refractive index of the first dielectric layer 106 is n1, and the refractive index of the second dielectric layer 107 is n2. For example, the first dielectric layer 106 and the second dielectric layer 107 have the function of hole transport or electron transport.

For example, as illustrated by Fig. 12, the through hole 101 is filled with a medium with a refractive index n0, the medium can be a gas (for example, air), a solid or a liquid material. In one example, the medium filled in the through hole 101 may also be the same as the material of the photonic crystal part 100.

The embodiments of the present disclosure do not limit the magnitude relationship among the refractive index n0 of the medium filled in the through hole 101, the refractive index n1 of the first dielectric layer 106, and the refractive index n2 of the second dielectric layer 107. In practical application, the medium filled in the through hole 101, the first dielectric layer 106, and the second dielectric layer 107 can be set to have the same refractive index or different refractive indexes as required, and the embodiments of the present disclosure are not limited thereto.

For example, in the embodiments of the present disclosure, a filling rate and a filling shape of the medium in the through hole 101 can also be adjusted as required. For example, in one example, the lower half of the through hole 101 can be filled or only one side of the through hole 101 can be filled, or the through hole 101 can be filled in any other filling manner. The materials of the first dielectric layer 106, the photonic crystal part 100, the second dielectric layer 107, and the material of the media filled in the through hole 101 may be materials with or without optical gain.

For example, as illustrated by Fig. 12, the photonic crystal laser 10 further includes an n-type substrate 201, an n-type semiconductor heavily doped layer 202 and an n-type semiconductor doped layer 203 sequentially arranged on the n-type substrate 201, a p-type semiconductor doped layer 204 and a p-type semiconductor heavily doped layer 205 sequentially arranged at a side of the active layer 105 away from the n-type substrate 201, a p-type electrode layer 206 arranged at a side of the p-type semiconductor heavily doped layer 205 away from the n-type substrate 201, and an n-type electrode layer 207 arranged at a side of the n-type semiconductor heavily doped layer 202 away from the n-type substrate 201 and spaced apart from the n-type semiconductor doped layer 203. The active layer 105 is arranged at a side of the n-type semiconductor doped layer 203 away from the n-type substrate 201, the p-type semiconductor heavily doped layer 205 is configured as the second dielectric layer 107, and the p-type semiconductor doped layer 204 is configured as the photonic crystal part 100 and the first dielectric layer 106.

For example, in the structure shown in Fig. 12, the photonic crystal part 100 and the first dielectric layer 106 are formed in the same process step and are integrally formed, and both the photonic crystal part 100 and the first dielectric layer 106 are formed by the p-type semiconductor doped layer 204. It should be noted that if the first dielectric layer 106 is not left under the photonic crystal part 100 to preventing the p-type semiconductor doped layer 204 from being penetrated, the active layer 105 may be damaged in the process of forming the photonic crystal part 100, thus weakening the light emission and light gain performance of the active layer 105.

For example, the material of the n-type substrate 201 includes, but is not limited to, GaAs, InP, GaSb or GaN, or the n-type substrate 201 may be a substrate formed by bonding a layer structure formed of GaAs, InP, GaSb or GaN on a Si substrate by a bonding process or a flip-chip bonding process.

For example, the structure of the active layer 105 includes a quantum well, a quantum wire or a quantum dot; the material of the active layer 105 includes, but is not limited to, GaAs, AlGaAs, InGaAs, InGaAsP, GaAsP, AlGaInAs, or InGaN, and the active layer 105 can be used to provide optical gain, and the peak wavelength range of the gain spectrum covers ultraviolet to far infrared bands.

For example, the material of the n-type electrode layer 207 includes metals such as Au, AuGe, AuGe/Au, AuGeNiAu, metal alloys, and transparent conductive materials such as indium tin oxide (ITO).

For example, the material of the p-type electrode layer 206 includes, but is not limited to, metals such as Au, Ti, Pt, Cr, and metal alloys such as TiPtAu, AuZnAu, NiAg or CrAu. For example, the p-type electrode layer 206 can be prepared by a stripping method, a wet etching method or a dry etching method. For example, in the case that the dry etching method is used, the gas used is not limited to fluorocarbon gas, but based on chlorine gas or hydroiodic acid gas. In addition, the inert gases such as argon and xenon need to be mixed into chlorine gas or hydroiodic acid gas, and the ratio between chlorine gas or hydroiodic acid gas and inert gas is approximately 2:1.

For example, the p-type semiconductor heavily doped layer 205 is formed on the photonic crystal part 100 by epitaxial growth or bonding.

For example, the materials of other layer structures of the photonic crystal laser 10 can be selected with reference to conventional materials, which are not limited by the embodiments of the present disclosure. The thickness of each layer structure of the photonic crystal laser 10 can refer to the conventional design as required, which is not limited by the embodiments of the present disclosure.

It should be noted that the through hole 101 may also be formed in the p-type semiconductor heavily doped layer 205 as the photonic crystal part 100.

For example, the working process of the photonic crystal laser 10 illustrated by Fig. 12 is provided as follows: in the case that a positive voltage is applied to the p-type electrode layer 206, holes are injected from the p-type semiconductor heavily doped layer 205 to the active layer 105, and electrons are injected from the n-type semiconductor heavily doped layer 202 to the active layer 105. When the holes and the electrons (carriers) are injected into the active layer 105, the carriers recombine to emit light. The wavelength of the emitted light is defined by the energy band gap of the semiconductor layer included in the active layer 105.

For example, the p-type semiconductor heavily doped layer 205, the photonic crystal layer 204 to the n-type semiconductor heavily doped layer 202 constitute a multilayer dielectric layer structure, and the light emitted from the active layer 105 excites the optical mode of the dielectric layer, and some of the lost light reaches the photonic crystal part 100 and diffracts with the periodic structure of the photonic crystal part 100. In the case that there is a limited matching relationship between the wavelength of the optical mode and the established period of the photonic crystal in the photonic crystal part 100, the layered structure and the photonic crystal generate a stable resonance mode, which becomes a laser lasing mode.

For example, Fig. 13 is a schematic cross-sectional structural diagram of another photonic crystal laser provided by at least one embodiment of the present disclosure. As illustrated by Fig. 13, the photonic crystal laser 10 further includes an n-type substrate 201, an n-type semiconductor heavily doped layer 202 and an n-type semiconductor doped layer 203 sequentially arranged on the n-type substrate 201, a p-type semiconductor doped layer 204 and a p-type semiconductor heavily doped layer 205 sequentially arranged at a side of the active layer 105 away from the n-type substrate 201, a p-type electrode layer 206 arranged at a side of the p-type semiconductor heavily doped layer 205 away from the n-type substrate 201, and an n-type electrode layer 207 arranged at a side of the n-type semiconductor heavily doped layer 202 away from the n-type substrate 201 and spaced apart from the n-type semiconductor doped layer 203; the active layer 105 is arranged at a side of the n-type semiconductor doped layer 203 away from the n-type substrate 201; the n-type semiconductor heavily doped layer 202 is configured as the second dielectric layer 107, and n-type semiconductor doped layer 203 is configured as the photonic crystal part 100 and the first dielectric layer 106.

For example, in the structure shown in Fig. 13, it is needed to set a first dielectric layer 106 between the photonic crystal part 100 and the active layer 105, and the first dielectric layer 106 can also be made of n-type semiconductor doped material to prevent the material of the active layer 105 from filling the through hole 101 in the photonic crystal part 100 after the photonic crystal part 100 with the through hole 101 is formed. In addition, if a first dielectric layer 106 is not specially arranged between the n-type semiconductor doped layer 203 and the active layer 105, it is not conducive to the epitaxial growth of the active layer 105.

For example, the working process of the photonic crystal laser 10 illustrated by Fig. 13 is provided as follows: in the case that a positive voltage is applied to the p-type electrode layer 206, holes are injected from the p-type semiconductor heavily doped layer 205 to the active layer 105, and electrons are injected from the n-type semiconductor heavily doped layer 202 to the active layer 105; when holes and electrons (carriers) are injected into the active layer 105, the carriers recombine to emit light. The wavelength of the emitted light is defined by the energy band gap of the semiconductor layer included in the active layer 105.

For example, the p-type semiconductor heavily doped layer 205, the photonic crystal layer 204 to the n-type semiconductor heavily doped layer 202 constitute a multilayer dielectric layer structure, and the light emitted from the active layer 105 excites the optical mode of the dielectric layer, and some of the lost light reaches the photonic crystal part 100 and diffracts with the periodic structure of the photonic crystal part 100. In the case that there is a limited matching relationship between the wavelength of the optical mode and the established period of the photonic crystal in the photonic crystal part 100, the layered structure and the photonic crystal generate a stable resonance mode, which becomes a laser lasing mode.

For example, the material and thickness of each layer structure included in the photonic crystal laser 10 shown in Fig. 13 can be referred to the above-mentioned description in Fig. 12, and will not be repeated herein.

For example, in the embodiments of the present disclosure, the photonic crystal laser 10 shown in Fig. 12 and Fig. 13 includes a single-mode photonic crystal laser and a multimode photonic crystal laser.

At least one embodiment of the present disclosure further provides a preparing method of a photonic crystal laser, which includes the following steps: providing a base substrate, forming a first type semiconductor doped layer film on the base substrate, applying a resist on the first type semiconductor doped layer film, and pre-curing the resist to form a resist layer, nanoimprinting the resist layer by using an imprint template to transfer a pattern of the imprint template to the resist layer, and curing the resist layer to form a resist layer pattern, patterning the first type semiconductor doped layer film with the resist layer pattern as a mask to form a photonic crystal layer, and removing the resist layer pattern; the photonic crystal layer includes a plurality of through holes arranged in an array, a central region and a peripheral region surrounding the central region, the plurality of through holes include first through holes arranged in an array in the central region and second through holes arranged in an array in the peripheral region, a relative arrangement density of the first through holes is different from a relative arrangement density of the second through holes, and in the same direction, the variance of the first distances between any two adjacent first through holes ranges from 1 nm² to 100 nm². Using nanoimprint lithography to prepare photonic crystal layer can reduce production cost and improve production efficiency, and it is suitable for large-scale production, so it is not needed to use electron beam lithography to produce photonic crystal layer with the variance of the first distances larger than 0 nm² and smaller than 1 nm². Moreover, using electron beam lithography method will greatly reduce production efficiency and increase production cost, and it cannot guarantee robustness. In addition, the quality factor of photonic crystal layer prepared by electron beam lithography method is not obviously improved compared with the quality factor of photonic crystal layer prepared by nanoimprint lithography technology.

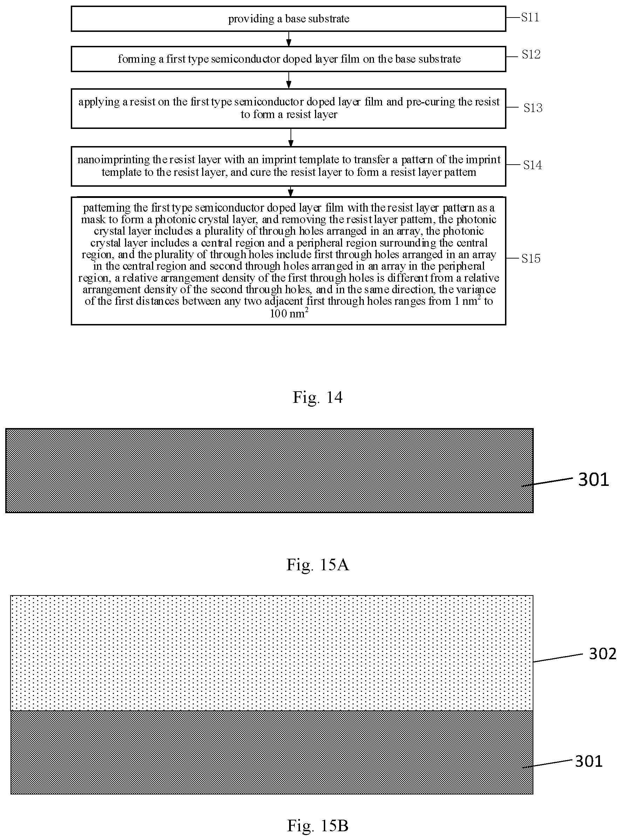

For example, Fig. 14 is a flowchart of a preparing method of a photonic crystal laser provided by at least one embodiment of the present disclosure, and as illustrated by Fig. 14, the preparing method includes the following steps.

S11: providing a base substrate.

S12: forming a first type semiconductor doped layer film on the base substrate.

S13: applying a resist on the first type semiconductor doped layer film and pre-curing the resist to form a resist layer.

S14: nanoimprinting the resist layer with an imprint template to transfer a pattern of the imprint template to the resist layer, and cure the resist layer to form a resist layer pattern.

S15: patterning the first type semiconductor doped layer film with the resist layer pattern as a mask to form a photonic crystal layer, and removing the resist layer pattern, the photonic crystal layer includes a plurality of through holes arranged in an array, the photonic crystal layer includes a central region and a peripheral region surrounding the central region, and the plurality of through holes include first through holes arranged in an array in the central region and second through holes arranged in an array in the peripheral region, a relative arrangement density of the first through holes is different from a relative arrangement density of the second through holes, and in the same direction, the variance of the first distances between any two adjacent first through holes ranges from 1 nm² to 100 nm².

For example, the planar structure of the photonic crystal part included in the photonic crystal layer formed by this method can be seen in any one of the above-mentioned Fig. 2 to Fig. 11. Combined with the above-mentioned Fig. 2 to Fig. 11, the photonic crystal part 100 includes a plurality of through holes 101 arranged in an array, the photonic crystal part 100 includes a central region 102 and a peripheral region 103 surrounding the central region 102, and the plurality of through holes 101 include first through holes 101a arranged in the central region 102 and second through holes 101b arranged in the peripheral region 103. A relative arrangement density of the first through holes 101a is different from a relative arrangement density of the second through holes 101b, and in the same direction, the variance of the first distances d1 between any two adjacent first through holes 101a ranges from 1 nm² to 100 nm².

For example, Fig. 15A to Fig. 15E are process diagrams of a preparing method of a photonic crystal laser provided by at least one embodiment of the present disclosure.

As illustrated by Fig. 15A, a base substrate 301 is provided, the base substrate 301 may be an n-type substrate, and the material of the n-type substrate includes but is not limited to GaAs, InP, GaSb or GaN, or the n-type substrate may be a base substrate formed by bonding a layer structure formed of GaAs, InP, GaSb or GaN on a Si substrate through a bonding process or a flip-chip bonding process.

For example, as illustrated by Fig. 15B, a first type semiconductor doped layer film 302 is formed on the base substrate 301. For example, the first type semiconductor doped layer film 302 may be an n-type semiconductor doped layer film or a p-type semiconductor doped layer film. For example, the first type semiconductor doped layer film 302 can be formed by epitaxial growth.

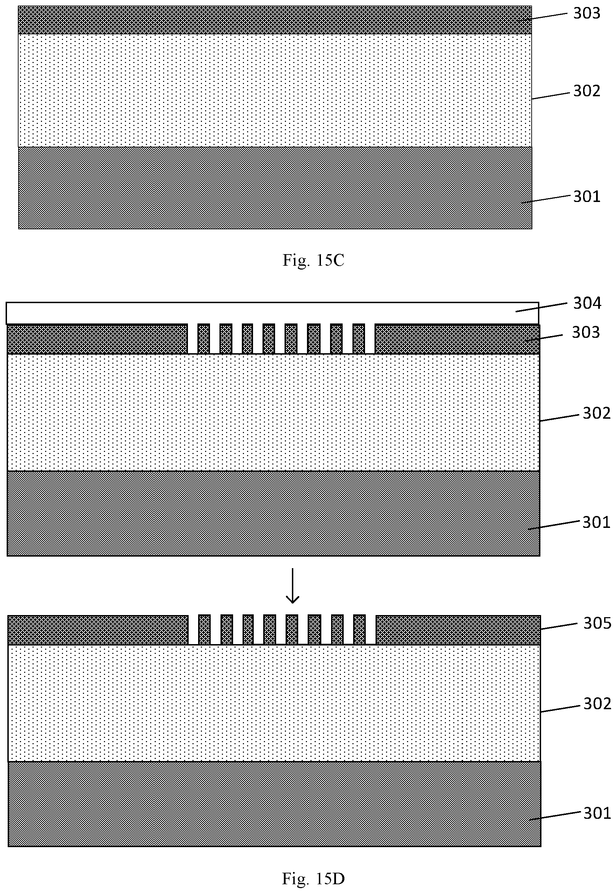

For example, as illustrated by Fig. 15C, a resist is applied on the first type semiconductor doped layer film 302, and is pre-cured to form a resist layer 303. For example, a liquid resist can be coated on the first type semiconductor doped layer film 302, and then the liquid resist is pre-cured to make it in a non-free flowing state, that is, a semi-solid state, and it can be ensured that the subsequent imprint template 304 can transfer its pattern to the resist layer 303. For example, the method of pre-curing the resist includes the method of ultraviolet irradiation or the method of cooling and curing.

For example, as illustrated by Fig. 15D, the resist layer 303 is nanoimprinted with an imprint template 304 to transfer the pattern of the imprint template 304 to the resist layer 303, and the resist layer 303 is cured to form a resist layer pattern 305. That is, in Fig. 15D, the process of transferring the pattern of the imprint template 304 to the resist layer 303 is completed. For example, a part of the first type semiconductor doped layer film that is covered by the resist layer pattern 305 is a reserved part of the first type semiconductor doped layer film, and the uncovered part of the first type semiconductor doped layer film is a part to be removed by etching. For example, the nanoimprint technology includes ultraviolet nanoimprint technology or thermal nanoimprint technology. For example, the method of curing the resist layer 303 includes a method of ultraviolet irradiation or a method of cooling and curing.

For example, in one example, the technology of nanoimprinting the resist layer 303 is ultraviolet nanoimprint technology, and the method of curing the resist layer 303 is ultraviolet irradiation; in another example, the technology of nanoimprinting the resist layer 303 is thermal nanoimprint technology, and the method of curing the resist layer 303 is cooling and curing.

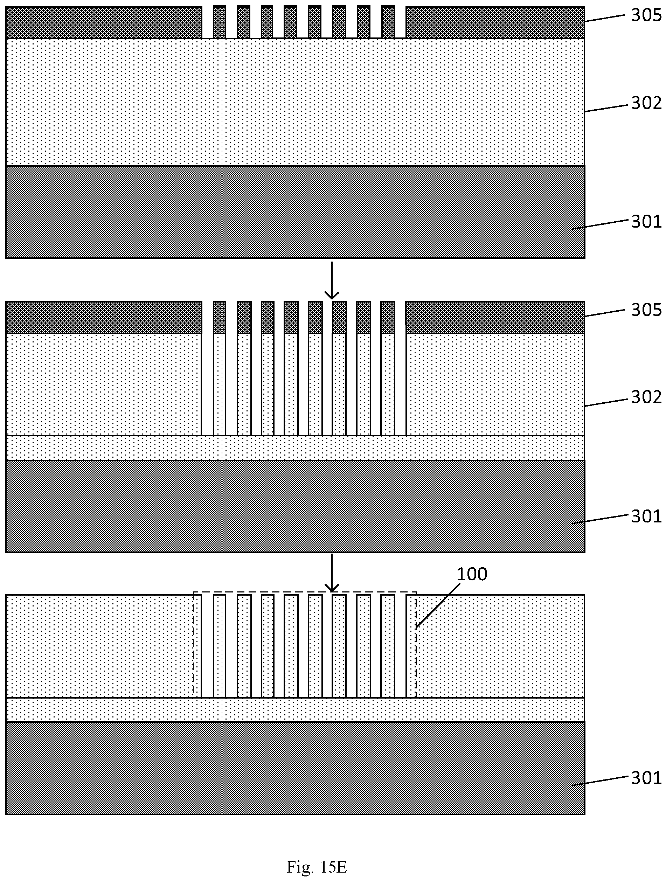

For example, as illustrated by Fig. 15E, the first type semiconductor doped layer film 302 is patterned with the resist layer pattern 305 as a mask to form a photonic crystal layer, and the resist layer pattern 305 is removed. The planar structure of the photonic crystal part 100 included in the photonic crystal layer can be seen in the above-mentioned

Fig. 2 to Fig. 11, and will not be described here again.

It should be noted that in Fig. 15E, a part of the first type semiconductor doped layer film 302 close to the base substrate 301 is reserved as the first dielectric layer. In other embodiments, the first type semiconductor doped layer film 302 may be etched through, and the part of the first type semiconductor doped layer film 302 close to the base substrate 301 is not reserved.

For example, it should also be noted that the first type semiconductor doped layer film may be a first type semiconductor heavily doped layer film.

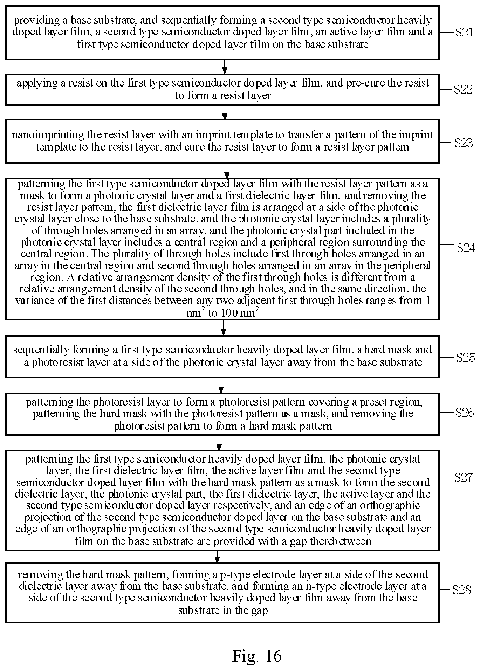

For example, Fig. 16 is a flowchart of another preparing method of a photonic crystal laser provided by at least one embodiment of the present disclosure. As illustrated by Fig. 16, the preparing method includes the following steps.

S21: providing a base substrate, and sequentially forming a second type semiconductor heavily doped layer film, a second type semiconductor doped layer film, an active layer film and a first type semiconductor doped layer film on the base substrate.

S22: applying a resist on the first type semiconductor doped layer film, and precure the resist to form a resist layer.

S23: nanoimprinting the resist layer with an imprint template to transfer a pattern of the imprint template to the resist layer, and curing the resist layer to form a resist layer pattern.

S24: patterning the first type semiconductor doped layer film with the resist layer pattern as a mask to form a photonic crystal layer and a first dielectric layer film, and removing the resist layer pattern, the first dielectric layer film is arranged at a side of the photonic crystal layer close to the base substrate, and the photonic crystal layer includes a plurality of through holes arranged in an array, and the photonic crystal part included in the photonic crystal layer includes a central region and a peripheral region surrounding the central region. The plurality of through holes include first through holes arranged in an array in the central region and second through holes arranged in an array in the peripheral region. A relative arrangement density of the first through holes is different from a relative arrangement density of the second through holes, and in the same direction, the variance of the first distances between any two adjacent first through holes ranges from 1 nm² to 100 nm².

S25: sequentially forming a first type semiconductor heavily doped layer film, a hard mask and a photoresist layer at a side of the photonic crystal layer away from the base substrate.

S26: patterning the photoresist layer to form a photoresist pattern covering a preset region, patterning the hard mask with the photoresist pattern as a mask, and removing the photoresist pattern to form a hard mask pattern.

S27: patterning the first type semiconductor heavily doped layer film, the photonic crystal layer, the first dielectric layer film, the active layer film and the second type semiconductor doped layer film with the hard mask pattern as a mask to form the second dielectric layer, the photonic crystal part, the first dielectric layer, the active layer and the second type semiconductor doped layer respectively, and an edge of an orthographic projection of the second type semiconductor doped layer on the base substrate and an edge of an orthographic projection of the second type semiconductor heavily doped layer film on the base substrate are provided with a gap therebetween.

S28: removing the hard mask pattern, forming a p-type electrode layer at a side of the second dielectric layer away from the base substrate, and forming an n-type electrode layer at a side of the second type semiconductor heavily doped layer film away from the base substrate in the gap.

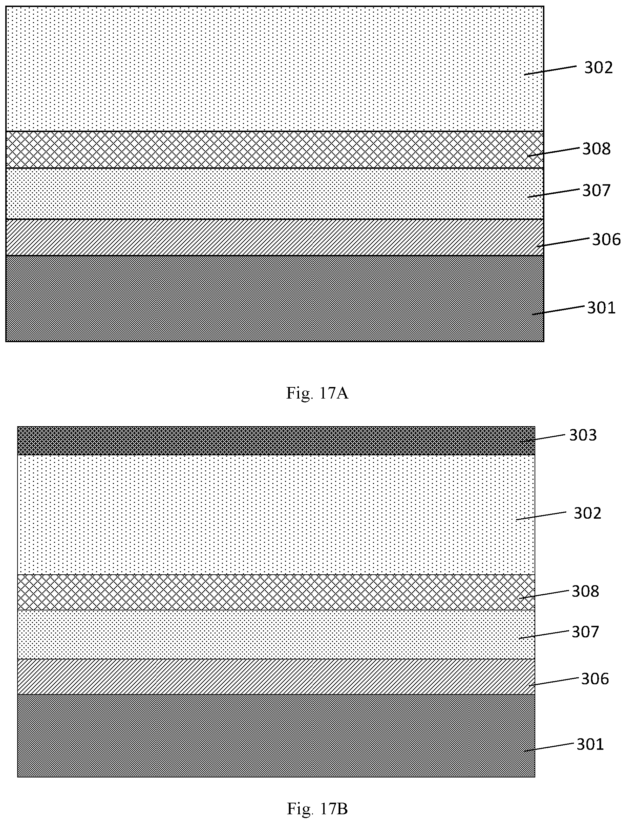

For example, Fig. 17A to Fig. 17H are process diagrams of a preparing method of a photonic crystal laser provided by at least one embodiment of the present disclosure.

For example, as illustrated by Fig. 17A, a base substrate 301 is provided, and a second type semiconductor heavily doped layer film 306, a second type semiconductor doped layer film 307, an active layer film 308 and a first type semiconductor doped layer film 302 are sequentially formed on the base substrate 301.

For example, the first type semiconductor doped layer film 302 is a p-type semiconductor doped layer film, the second type semiconductor doped layer film 307 is an n-type semiconductor doped layer film, and the second type semiconductor heavily doped layer film 306 is an n-type semiconductor heavily doped layer film. The n-type semiconductor heavily doped layer film 306, the n-type semiconductor doped layer film 307, the active layer film 308 and the p-type semiconductor doped layer film 302 are sequentially stacked on the base substrate 301. For example, the p-type semiconductor doped layer film can be formed by epitaxial growth.

For example, the active layer formed by the active layer film 308 can emit light and can be used as an optical gain medium. The material of the active layer film 308 can refer to the relevant design mentioned above and will not be described here.

For example, as illustrated by Fig. 17B, a resist is applied on the first type semiconductor doped layer film 302 and the resist is pre-cured to form a resist layer 303, that is, the resist is applied on the n-type semiconductor doped layer film 302 and pre-cured to form the resist layer 303. For example, a liquid resist can be coated on the n-type semiconductor doped layer film 302, and then the liquid resist is pre-cured to make it in a non-free flowing state, that is, a semi-solid state, and it can be ensured that the imprint template 304 mentioned later can transfer its pattern to the resist layer 303. For example, the method of pre-curing the resist includes the method of ultraviolet irradiation or the method of cooling and curing.

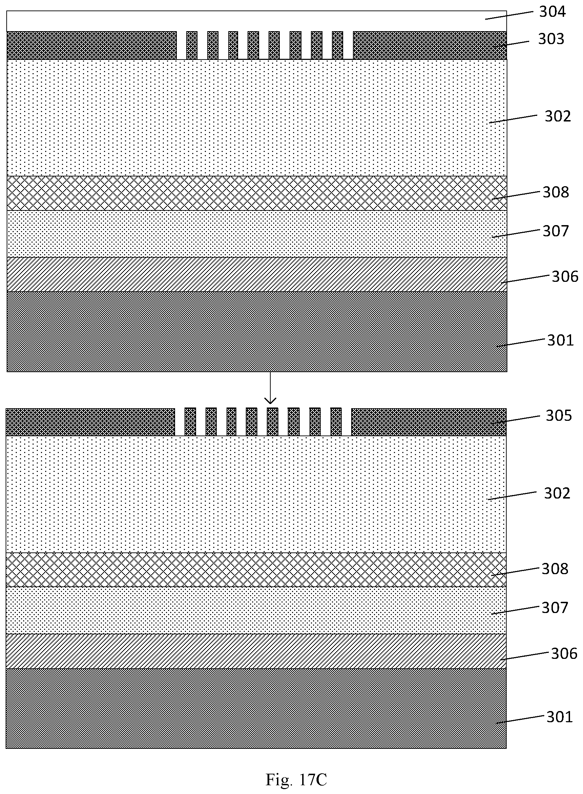

For example, as illustrated by Fig. 17C, the resist layer 303 is nanoimprinted with an imprint template 304 to transfer a pattern of the imprint template 304 to the resist layer 303, and the resist layer 303 is cured to form a resist layer pattern 305.

For example, the nanoimprint technology includes ultraviolet nanoimprint technology or thermal nanoimprint technology.

For example, the method of curing the resist layer 303 includes a method of ultraviolet irradiation or a method of cooling and curing.

For example, in one example, the technology of nanoimprinting the resist layer 303 is ultraviolet nanoimprint technology, and the method of curing the resist layer 303 is ultraviolet irradiation; In another example, the technology of nanoimprinting the resist layer 303 is thermal nanoimprint technology, and the method of curing the resist layer 303 is cooling and curing.

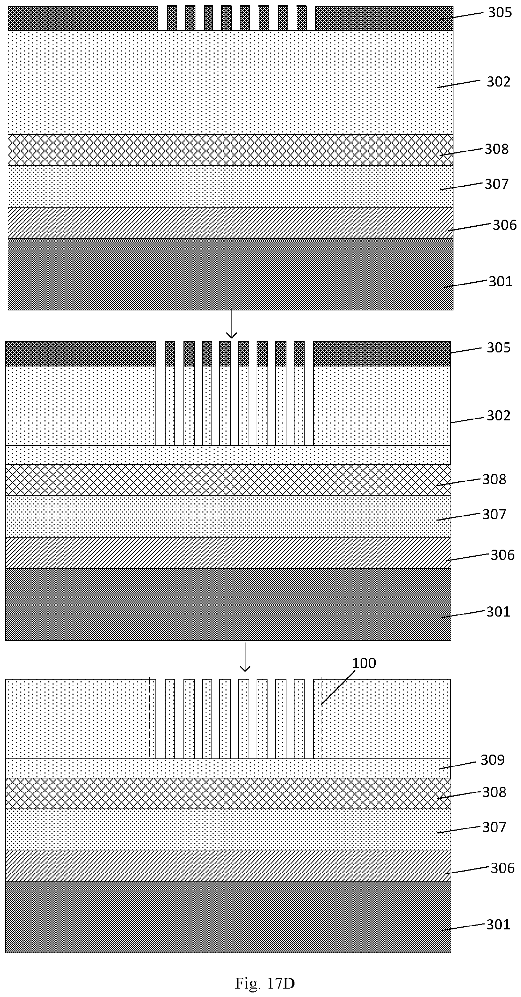

For example, as illustrated by Fig. 17D, a first type semiconductor doped layer film 302 (p-type semiconductor doped layer film) is patterned with the resist layer pattern 305 as a mask to form a photonic crystal layer and a first dielectric layer film 309, and the resist layer pattern 305 is removed. The first dielectric layer film 309 is at a side of the photonic crystal layer close to the base substrate 301, and the planar structure of the photonic crystal part 100 included in the photonic crystal layer can be seen in the above-mentioned Fig. 2 to Fig. 11, and will not repeated herein.

For example, the photonic crystal parts prepared by nanoimprint technology include holes of various shapes, hole arrays, nano-grooves of various shapes, and combinations of various nanostructures, which are not limited by the embodiments of the present disclosure.

For example, in the process of patterning the p-type semiconductor doped layer film with the resist layer pattern 305 as a mask to form the photonic crystal layer, a first dielectric layer film 309 is formed at a side of the photonic crystal layer close to the base substrate 301, and the photonic crystal layer and the first dielectric layer film 309 are of an integrated structure. The first dielectric layer film 309 has a certain thickness and remains in the region corresponding to the through holes 101, that is, the first dielectric layer film 309 is a continuous one-layer structure.

For example, as illustrated by Fig. 17D, the first dielectric layer film 309 is formed between the active layer film 308 and the photonic crystal layer. The existence of the first dielectric layer film 309 can prevent the first type semiconductor doped layer film 302 from being etched through, so as to prevent the performance of the active layer film 308 from being affected.

For example, a part of the first type semiconductor doped layer film 302 that is covered by the resist layer pattern 305 is a reserved part of the first type semiconductor doped layer film, and the uncovered part is a part of first type semiconductor doped layer film 302 to be removed by etching.

For example, as illustrated by Fig. 17D, the second type semiconductor doped layer film 307 and the active layer film 308 are arranged on the same surface of the base substrate 301 as the photonic crystal layer 100, the second type semiconductor doped layer film 307, the active layer film 308 and the photonic crystal layer are stacked arranged, and the active layer film 308 is sandwiched between the photonic crystal layer 100 and the second type semiconductor doped layer film 306, and the second type semiconductor heavily doped layer film 306 is formed at a side of the second type semiconductor doped layer film 307 away from the active layer film 308.

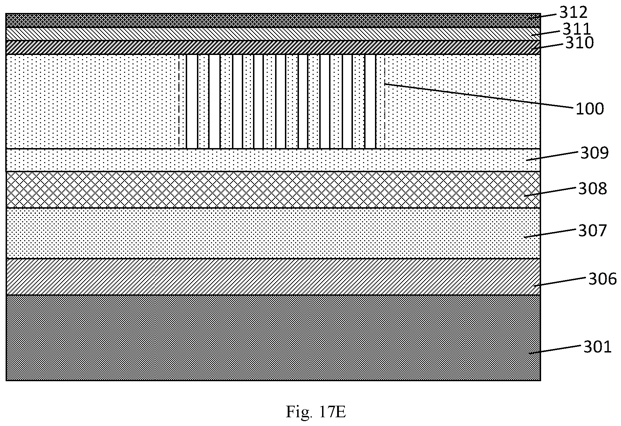

For example, as illustrated by Fig. 17E, a first type semiconductor heavily doped layer film 310 (p-type semiconductor heavily doped layer film), a hard mask 311 and a photoresist layer 312 are sequentially formed at a side of the photonic crystal layer away from the base substrate 301.

For example, the first type semiconductor heavily doped layer film 310 can be formed on a surface of the photonic crystal layer by epitaxial growth. The material of the hard mask 311 includes silicon dioxide, which can be formed by epitaxial growth or coating, and then a photoresist layer 312 is coated on the hard mask 311.

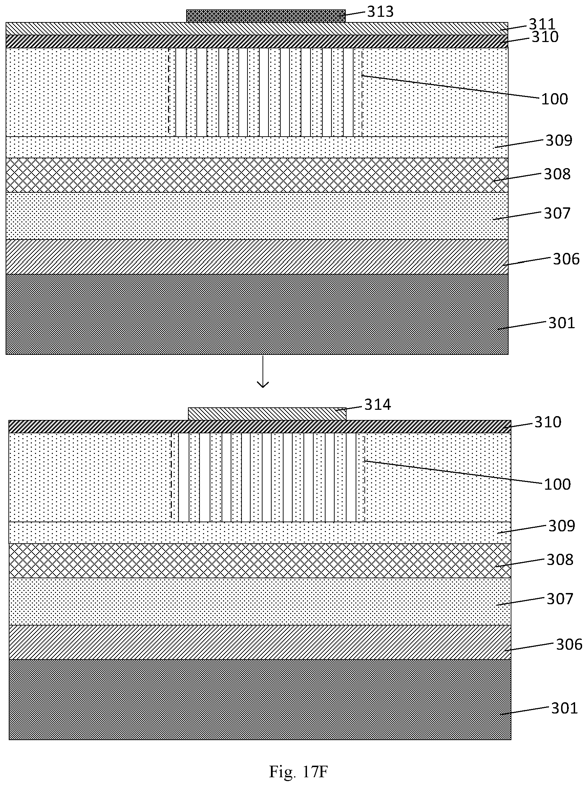

For example, as illustrated by Fig. 17F, the photoresist layer 312 is patterned to form a photoresist pattern 313 covering a preset region, and the hard mask 311 is patterned by using the photoresist pattern 313 as a mask to form a hard mask pattern 314, and then the photoresist pattern 313 is removed.

For example, the preset region is a mesa region of the photonic crystal laser. The mesa region of the photonic crystal laser can be defined by electron beam lithography and development, and then the hard mask 311 except the mesa region is etched away to form the hard mask pattern 314.

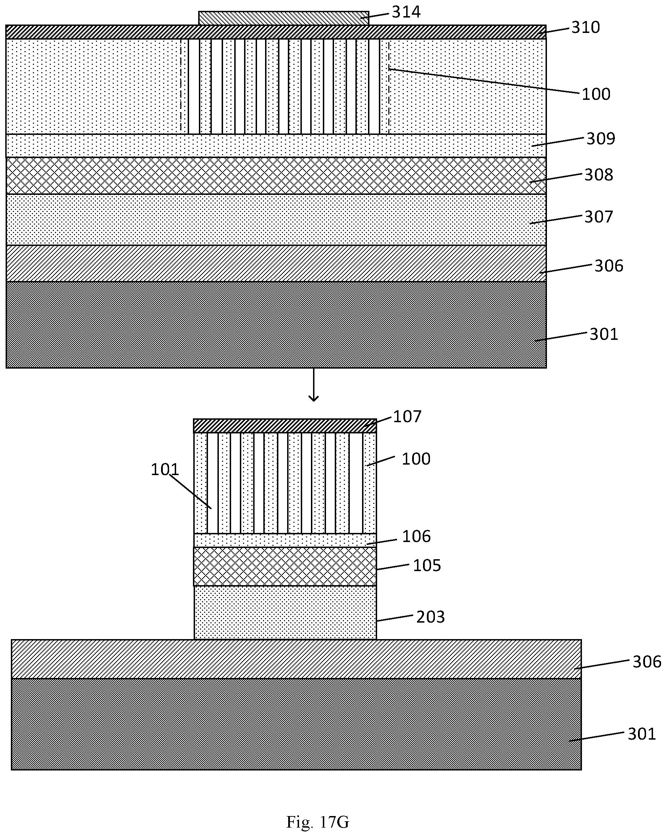

For example, as illustrated by Fig. 17G, by using the hard mask pattern 314 as a mask, the first type semiconductor heavily doped layer film 310 (second dielectric layer film), photonic crystal layer, first dielectric layer film 309, active layer film 308 and second type semiconductor doped layer film 307 (n-type semiconductor doped layer film) are patterned to form the second dielectric layer 107, the photonic crystal part 100, the first dielectric layer 106, the active layer 105 and the second type semiconductor doped layer 203 (n-type semiconductor doped layer 203), respectively, and an edge of an orthographic projection of the second type semiconductor doped layer 203 (n-type semiconductor doped layer 203) on the base substrate 301 and an edge of the orthographic projection of the second type semiconductor heavily doped layer film 306 (n-type semiconductor heavily doped layer film) on the base substrate 301 are provided with a gap therebetween. That is, the mesa of the photonic crystal laser is etched with the hard mask pattern 314 as a mask until the second type semiconductor heavily doped layer film 306 is exposed, and then the hard mask pattern 314 is removed.

For example, as illustrated by Fig. 17G, the first type semiconductor heavily doped layer film 310 can be used as a second dielectric layer film, the second dielectric layer film can form a second dielectric layer 107 through subsequent etching process. Combining with Fig. 12, each of the through holes 101 includes a first end 1011 and a second end 1012 which are opposite along the extending direction of a channel thereof, the first end 1011 is connected with the first dielectric layer 106 and the second end 1012 is connected with the second dielectric layer.

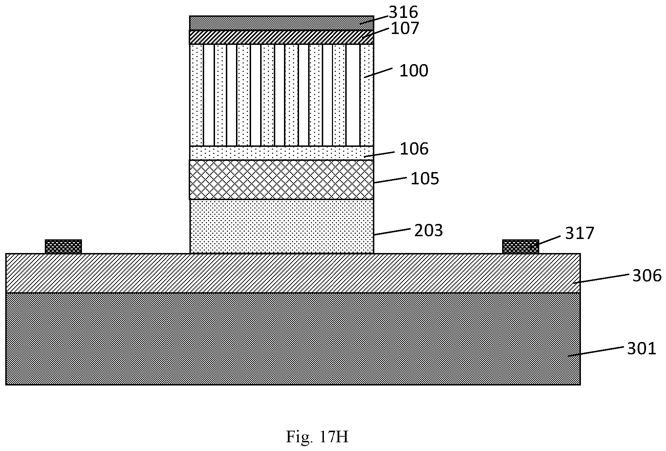

For example, as illustrated by Fig. 17H, the hard mask pattern 314 is removed, and a p-type electrode layer 316 is formed at a side of the second dielectric layer 107 away from the base substrate 301, and an n-type electrode layer 317 is formed at a side of the second type semiconductor heavily doped layer film 306 away from the base substrate 301 in the gap.

For example, the p-type electrode layer 316 can be formed by depositing a p-type electrode material, and the n-type electrode layer 317 can be formed by depositing an n-type electrode material. The embodiments of the present disclosure are not limited thereto, as long as the p-type electrode layer 316 and the n-type electrode layer 317 can be prepared.

For example, the structure of the photonic crystal laser formed by the processes of Fig. 17A to Fig. 17H can refer to the related descriptions in the above-mentioned Fig. 12, and will not be described herein.

It should be noted that the photonic crystal part can also be formed in the first type semiconductor heavily doped layer film 310. In this case, it is only needed to exchange the formation steps of the first type semiconductor heavily doped layer film 310 and the first type semiconductor doped layer film 302, and other process steps remain unchanged.

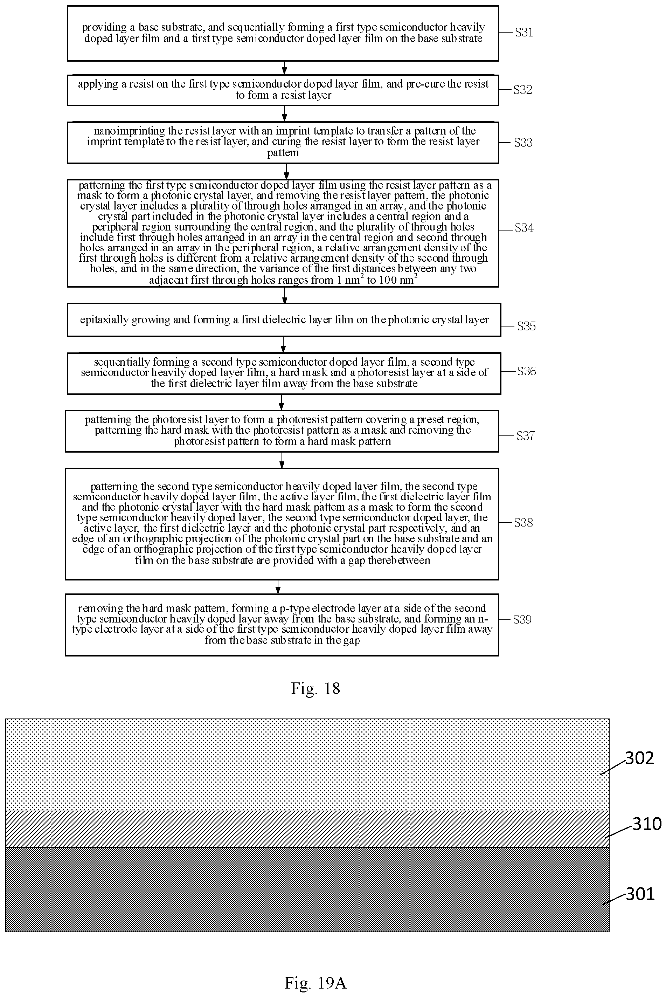

For example, Fig. 18 is a flowchart of another preparing method of a photonic crystal laser provided by at least one embodiment of the present disclosure. As illustrated by Fig. 18, the preparing method of a photonic crystal laser includes the following steps.

S31: providing a base substrate, and sequentially forming a first type semiconductor heavily doped layer film and a first type semiconductor doped layer film on the base substrate.

S32: applying a resist on the first type semiconductor doped layer film, and precure the resist to form a resist layer.

S33: nanoimprinting the resist layer with an imprint template to transfer a pattern of the imprint template to the resist layer, and curing the resist layer to form the resist layer pattern.

S34: patterning the first type semiconductor doped layer film using the resist layer pattern as a mask to form a photonic crystal layer, and removing the resist layer pattern, the photonic crystal layer includes a plurality of through holes arranged in an array, and the photonic crystal part included in the photonic crystal layer includes a central region and a peripheral region surrounding the central region, and the plurality of through holes include first through holes arranged in an array in the central region and second through holes arranged in an array in the peripheral region, a relative arrangement density of the first through holes is different from a relative arrangement density of the second through holes, and in the same direction, the variance of the first distances between any two adjacent first through holes ranges from 1 nm² to 100 nm².

S35: epitaxially growing and forming a first dielectric layer film on the photonic crystal layer.

S36: sequentially forming a second type semiconductor doped layer film, a second type semiconductor heavily doped layer film, a hard mask and a photoresist layer at a side of the first dielectric layer film away from the base substrate.

S37: patterning the photoresist layer to form a photoresist pattern covering a preset region, patterning the hard mask with the photoresist pattern as a mask and removing the photoresist pattern to form a hard mask pattern.

S38: patterning the second type semiconductor heavily doped layer film, the second type semiconductor doped layer film, the active layer film, the first dielectric layer film and the photonic crystal layer with the hard mask pattern as a mask to form the second type semiconductor heavily doped layer, the second type semiconductor doped layer, the active layer, the first dielectric layer and the photonic crystal part respectively, and an edge of an orthographic projection of the photonic crystal part on the base substrate and an edge of an orthographic projection of the first type semiconductor heavily doped layer film on the base substrate are provided with a gap therebetween.

S39: removing the hard mask pattern, forming a p-type electrode layer at a side of the second type semiconductor heavily doped layer away from the base substrate, and forming an n-type electrode layer at a side of the first type semiconductor heavily doped layer film away from the base substrate in the gap.

For example, Fig. 19A to Fig. 19I are process diagrams of a preparing method of a photonic crystal laser provided by at least one embodiment of the present disclosure.

For example, as illustrated by Fig. 19A, a base substrate 301 is provided, and a first type semiconductor heavily doped layer film 310 and a first type semiconductor doped layer film 302 are sequentially formed on the base substrate 301.

For example, the first type semiconductor doped layer film 302 is an n-type semiconductor doped layer film, and the first type semiconductor heavily doped layer film 310 is an n-type semiconductor heavily doped layer film. The n-type semiconductor heavily doped layer film and the n-type semiconductor doped layer film are sequentially stacked on the base substrate 301. For example, the n-type semiconductor heavily doped layer film and the n-type semiconductor doped layer film can be formed by epitaxial growth. The second type semiconductor doped layer film mentioned later is a p-type semiconductor doped layer.

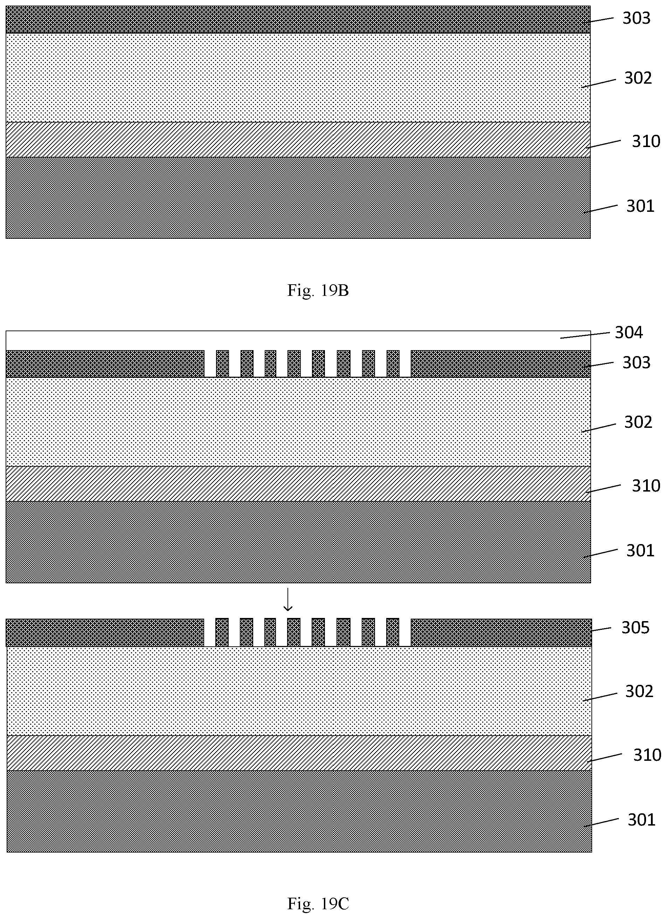

For example, as illustrated by Fig. 19B, a resist is applied on the first type semiconductor doped layer film 302, and the resist is pre-cured to form a resist layer 303, that is, the resist is applied on the n-type semiconductor doped layer film 302, and is pre-cured to form the resist layer 303. For example, a liquid resist can be coated on the n-type semiconductor doped layer film 302, and then the liquid resist is pre-cured to make it in a non-free flowing state, that is, a semi-solid state, and it can be ensured that the imprint template 304 can transfer its pattern to the resist layer 303. For example, the method of pre-curing the resist includes the method of ultraviolet irradiation or the method of cooling and curing.

For example, as illustrated by Fig. 19C, the resist layer 303 is nanoimprinted with an imprint template 304 to transfer the pattern of the imprint template 304 to the resist layer 303, and it is cured to form a resist layer pattern 305.

For example, the nanoimprint technology includes ultraviolet nanoimprint technology or thermal nanoimprint technology.

For example, the method of curing the resist layer 303 includes a method of ultraviolet irradiation or a method of cooling and curing.

For example, in one example, the technology of nanoimprinting the resist layer 303 is ultraviolet nanoimprint technology, and the method of curing the resist layer 303 is ultraviolet irradiation; in another example, the technology of imprinting the resist layer 303 is thermal nanoimprint technology, and the method of curing the resist layer 303 is cooling and curing.

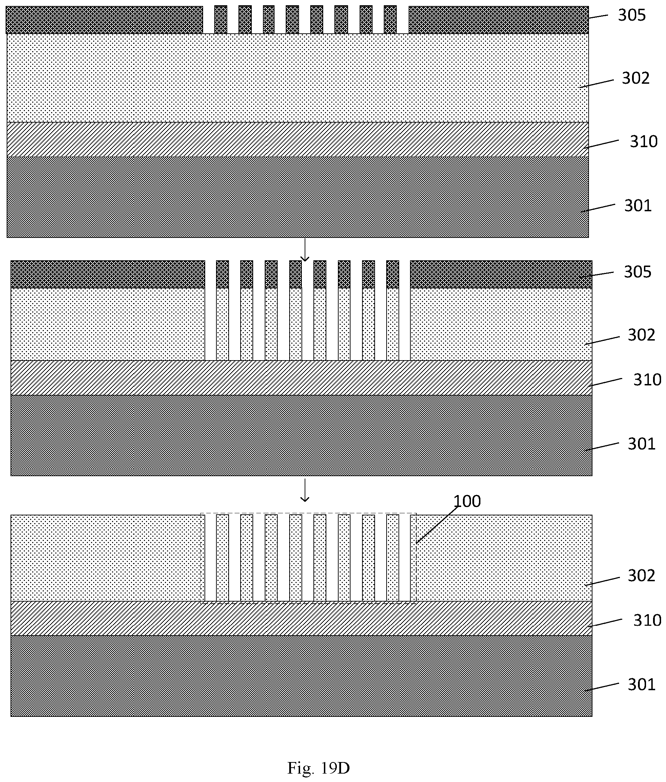

For example, as illustrated by Fig. 19D, the first type semiconductor doped layer film 302 (n-type semiconductor doped layer film) is patterned with the resist layer pattern 305 as a mask to form a photonic crystal layer, and the resist layer pattern 305 is removed. The photonic crystal layer includes a plurality of through holes arranged in an array, the photonic crystal part of the photonic crystal layer includes a central region and a peripheral region surrounding the central region; the plurality of through holes include first through holes arranged in an array in the central region and second through holes arranged in an array in the peripheral region; a relative arrangement density of the first through holes is different from a relative arrangement density of the second through holes; and in the same direction, the variance of the first distances between any two adjacent first through holes ranges from 1 nm² to 100 nm².

For example, a part of the first type semiconductor doped layer film 302 that is covered by the resist layer pattern 305 is a reserved part of the first type semiconductor doped layer film, and the uncovered part of the first type semiconductor doped layer film 302 is a part to be removed by etching.

For example, the photonic crystal part made by nanoimprint technology includes holes of various shapes, hole arrays, nano-grooves of various shapes, and combinations of various nanostructures, which are not limited by the embodiments of the present disclosure.

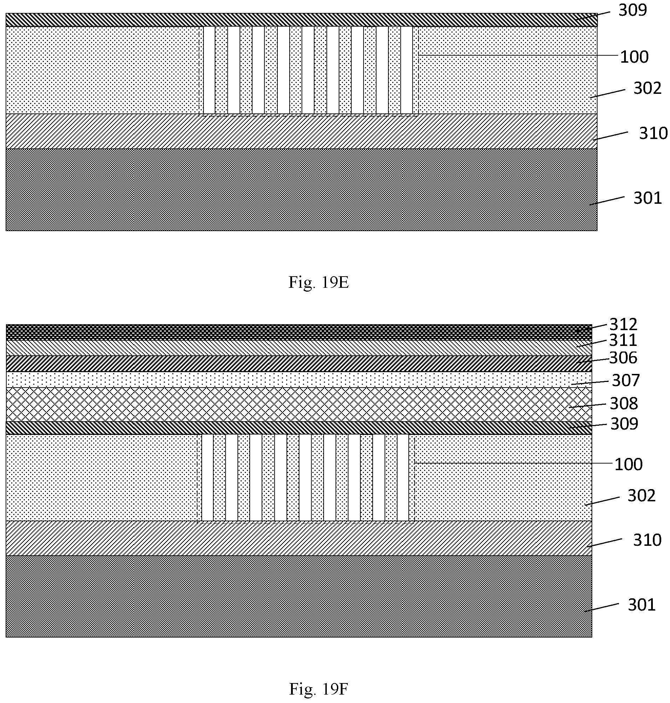

For example, as illustrated by Fig. 19E, a first dielectric layer film 309 is epitaxially grown on the photonic crystal layer.

For example, the first dielectric layer film 309 is arranged at a side of the photonic crystal layer away from the base substrate 301.

For example, as illustrated by Fig. 19F, an active layer film 308, a second type semiconductor doped layer film 307, a second type semiconductor heavily doped layer film 306, a hard mask 311 and a photoresist layer 312 are sequentially formed at a side of the first dielectric layer film 309 away from the base substrate 301.

For example, the second type semiconductor doped layer film 307 can be formed on a surface of the first dielectric layer film 309 by epitaxial growth. The material of the hard mask 311 includes silicon dioxide, the hard mask 311 can be formed by epitaxial growth or coating, and then a photoresist layer 312 is coated on the hard mask 311.

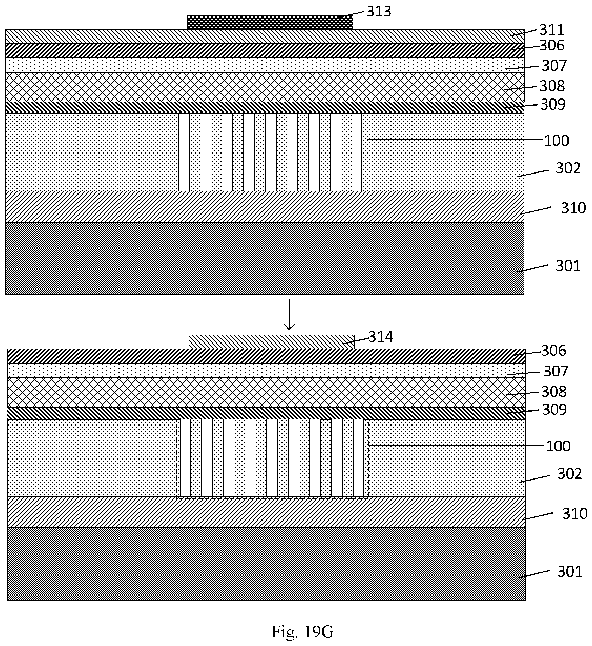

For example, as illustrated by Fig. 19G, the photoresist layer 312 is patterned to form a photoresist pattern 313 covering a preset region, and the hard mask 311 is patterned by using the photoresist pattern 313 as a mask to form a hard mask pattern 314, and then the photoresist pattern 313 is removed.

For example, the preset region is a mesa region of the photonic crystal laser. The mesa region of the photonic crystal laser can be defined by electron beam lithography and development, and then the hard mask 311 except the mesa region is etched away to form the hard mask pattern 314.

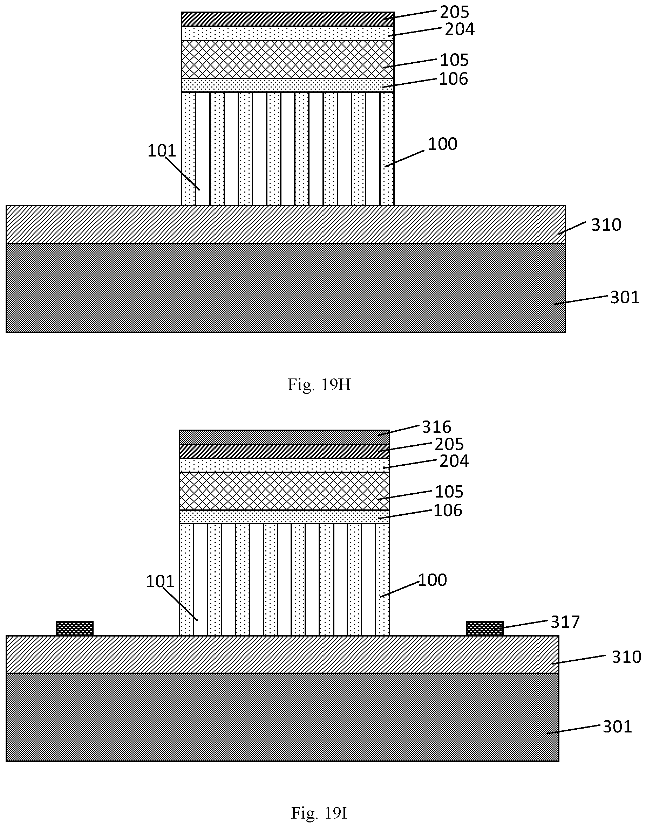

For example, as illustrated by Fig. 19H, by using the hard mask pattern 314 as a mask, the second type semiconductor heavily doped layer film 306, the second type semiconductor doped layer film 307, the active layer film 308, the first dielectric layer film 309 and the photonic crystal layer are patterned to form the second type semiconductor heavily doped layer (p-type semiconductor heavily doped layer 205), the second type semiconductor doped layer (p-type semiconductor doped layer 204), the active layer 105, the first dielectric layer 106 and the photonic crystal part 100, and an edge of an orthographic projection of the photonic crystal part 100 on the base substrate 301 and an edge of an orthographic projection of the first type semiconductor heavily doped layer film 310 (n-type semiconductor heavily doped layer film) on the base substrate 301 are provided with a gap therebetween. That is, the mesa of the photonic crystal laser is etched with the hard mask pattern 314 as a mask until the first type semiconductor heavily doped layer film 310 is exposed, and then the hard mask pattern 314 is removed.

For example, as illustrated by Fig. 19H, the active layer 105 can emit light and can be used as an optical gain medium, and the material of the active layer film 105 can refer to the relevant design mentioned above, and will not be repeated here.

For example, as illustrated by Fig. 19H, the first type semiconductor heavily doped layer film 310 can be used as the second dielectric layer film, and the second dielectric layer film is the second dielectric layer. With reference to Fig. 13, each of the through holes 101 includes a first end 1011 and a second end 1012 which are opposite along the extending direction of a channel thereof, the first end 1011 is connected with the first dielectric layer film 309 (the first dielectric layer is subsequently formed) and the second end 1012 is connected with the second dielectric layer film 310 (the second dielectric layer is subsequently formed).

For example, as illustrated by Fig. 19I, the hard mask pattern 314 is removed, and a p-type electrode layer 316 is formed at a side of the second type semiconductor heavily doped layer 205 away from the base substrate 301, and an n-type electrode layer 317 is formed at a side of the first type semiconductor heavily doped layer film 310 away from the base substrate 301 in the gap.

For example, the p-type electrode layer 316 can be formed by depositing a p-type electrode material, and the n-type electrode layer 317 can be formed by depositing an n-type electrode material. The embodiments of the present disclosure are not limited thereto, as long as the p-type electrode layer 316 and the n-type electrode layer 317 can be prepared.

For example, the structure of the photonic crystal laser formed by the processes of Fig. 19A to Fig. 19I can refer to the related descriptions in the above-mentioned Fig. 13, and will not be repeated here.

It should be noted that the photonic crystal part can also be formed in the first type semiconductor heavily doped layer film 310. In this case, it is only needed to exchange the formation steps of the first type semiconductor heavily doped layer film 310 and the first type semiconductor doped layer film 302, and other process steps remain unchanged.

The photonic crystal laser provided by at least one embodiment of the present disclosure and the preparing method thereof have at least one of the following beneficial technical effects:
(1) The preparing method of the photonic crystal laser provided by at least one embodiment of the present disclosure adopts nanoimprint technology to prepare photonic crystal layer on the basis of balancing robustness and quality factor (Q value), so as to reduce the production cost of the photonic crystal laser and improve the production efficiency, and make the preparing method suitable for large-scale production of photonic crystal laser.
(2) The preparing method provided by at least one embodiment of the present disclosure only needs to select an appropriate nanoimprint template according to the pattern of the through holes to be formed, and there are many kinds of nanoimprint templates, which can easily meet different pattern requirements. The cost of nanoimprinting template is low, and the photonic crystal part with different plane shapes or different plane sizes is only formed in one imprinting process, and other process conditions remain unchanged. However, for the commonly used electron beam lithography process, it is needed to change the process conditions to form through holes with different shapes or different plane sizes, and the exposure takes a long time, which will reduce the work efficiency and increase the production cost.

The following points need to be explained:
(1) The drawings of the embodiment of this disclosure only relate to the structure related to the embodiment of this disclosure, and other structures can refer to the general design.
(2) For the sake of clarity, in the drawings used to describe the embodiments of the present disclosure, the thickness of layers or regions is enlarged or reduced, that is, these drawings are not drawn to actual scale.
(3) In the case of no conflict, the embodiments of the present disclosure and the features in the embodiments can be combined with each other to obtain a new embodiment.

The above is only the specific implementation of this disclosure, but the protection scope of this disclosure is not limited to this, and the protection scope of this disclosure shall be subject to the protection scope of the claims.

## Claims

1. A photonic crystal laser, comprising: a photonic crystal part, wherein,
the photonic crystal part comprises a plurality of through holes arranged in an array,
the photonic crystal part comprises a central region and a peripheral region surrounding the central region, and the plurality of through holes comprise first through holes arranged in an array in the central region and second through holes arranged in an array in the peripheral region;
a relative arrangement density of the first through holes is different from a relative arrangement density of the second through holes, and, in a same direction, a variance of first distances between any two adjacent ones of the first through holes ranges from 1 nm² to 100 nm².

2. The photonic crystal laser according to claim 1, wherein a minimum distance between any two adjacent ones of the first through holes is a second distance, and a minimum distance between any two adjacent ones of the second through holes is a third distance, and the relative arrangement density of the first through holes is larger than the relative arrangement density of the second through holes, and the second distance is smaller than the third distance; or, the relative arrangement density of the first through holes is smaller than the relative arrangement density of the second through holes, and the second distance is larger than the third distance.

3. The photonic crystal laser according to claim 2, wherein a minimum distance between any adjacent first through hole and second through hole is a fourth distance, the relative arrangement density of the first through holes is larger than the relative arrangement density of the second through holes, and the fourth distance is larger than the second distance and smaller than the third distance; or, the relative arrangement density of the first through holes is smaller than the relative arrangement density of the second through holes, and the fourth distance is larger than the third distance and smaller than the second distance.

4. The photonic crystal laser according to any one of claims 1-3, wherein a transition region is further provided between the central region and the peripheral region, and the plurality of through holes further comprise third through holes arranged in an array in the transition region, and a minimum distance between any two adjacent ones of the third through holes is a fifth distance, and the relative arrangement density of the first through holes is larger than a relative arrangement density of the third through holes, and the relative arrangement density of the third through holes is larger than the relative arrangement density of the second through holes, the second distance is smaller than the fifth distance, and the fifth distance is smaller than the third distance; or, the relative arrangement density of the first through holes is smaller than the relative arrangement density of the third through holes, and the relative arrangement density of the third through holes is smaller than the relative arrangement density of the second through holes, the second distance is larger than the fifth distance, and the fifth distance is larger than the third distance.

5. The photonic crystal laser according to claim 4, wherein a minimum distance between adjacent third through hole and first through hole is a sixth distance, and a minimum distance between adjacent third through hole and second through hole is a seventh distance, the relative arrangement density of the first through holes is larger than the relative arrangement density of the third through holes, and the relative arrangement density of the third through holes is larger than the relative arrangement density of the second through holes, and the sixth distance is smaller than the fifth distance, and the fifth distance is smaller than the seventh distance; or, the relative arrangement density of the first through holes is smaller than relative arrangement density of the third through holes, and the relative arrangement density of the third through holes is smaller than relative arrangement density of the second through holes, and the sixth distance is larger than the fifth distance, and the fifth distance is larger than the seventh distance.

6. The photonic crystal laser according to claim 5, wherein each of the first through holes, each of the second through holes and each of the third through holes have a same plane shape and a same plane size.

7. The photonic crystal laser according to any one of claims 1-6, wherein the first through holes are arranged in a matrix, an overall outline shape of the first through holes arranged in the matrix is a rectangle shape, and the second through holes are respectively arranged at sides of edges of the rectangle shape away from a center of the central region, and the second through holes surround a whole of the first through holes arranged in the matrix.

8. The photonic crystal laser according to claim 7, wherein,
the matrix with the rectangle shape formed by the first through holes is a square matrix, and a plane shape of the central region is square shape;
the peripheral region comprises four edge regions and four corner regions, and shapes of the four edge regions and the four corner regions are all rectangular;
a long edge of each of the four edge regions close to the central region is aligned with a corresponding edge of four edges of the central region respectively and has a same length with the corresponding edge;
the four corner regions are respectively located in directions away from the center of the square shape at the four corners of the central region, and two adjacent edges of each of the four corner regions are respectively aligned with short edges, which are close to the two adjacent edges of each of the four corner regions, of two adjacent edge regions and have same length with the short edges of two adjacent edge regions.

9. The photonic crystal laser according to claim 8, wherein the four edge regions are all rectangular regions arranged by Na×Nb second through holes, and the four corner regions are all square regions arranged by Nb×Nb second through holes, and both Na and Nb are positive integers.

10. The photonic crystal laser according to any one of claims 1-9, further comprising an active layer and a first dielectric layer arranged between the active layer and the photonic crystal part, wherein the active layer is configured to emit light and serve as an optical gain medium.

11. The photonic crystal laser according to claim 10, further comprising a second dielectric layer arranged at a side of the photonic crystal part away from the first dielectric layer, wherein each of the through holes comprises a first end and a second end which are opposite along an extending direction of a channel thereof, the first end is connected with the first dielectric layer, and the second end is connected with the second dielectric layer.

12. The photonic crystal laser according to claim 11, further comprising:
an n-type substrate;
an n-type semiconductor heavily doped layer and an n-type semiconductor doped layer sequentially arranged on the n-type substrate;
a p-type semiconductor doped layer and a p-type semiconductor heavily doped layer sequentially arranged at a side of the active layer away from the n-type substrate;
a p-type electrode layer arranged at a side of the p-type semiconductor heavily doped layer away from the n-type substrate; and
an n-type electrode layer arranged at a side of the n-type semiconductor heavily doped layer away from the n-type substrate and spaced apart from the n-type semiconductor doped layer;
wherein, the active layer is arranged at a side of the n-type semiconductor doped layer away from the n-type substrate;
the p-type semiconductor heavily doped layer is configured as the second dielectric layer;
the p-type semiconductor doped layer is configured as the photonic crystal part and the first dielectric layer.

13. The photonic crystal laser according to claim 11, further comprising:
an n-type substrate;
an n-type semiconductor heavily doped layer and an n-type semiconductor doped layer sequentially arranged on the n-type substrate;
a p-type semiconductor doped layer and a p-type semiconductor heavily doped layer sequentially arranged at a side of the active layer away from the n-type substrate;
a p-type electrode layer arranged at a side of the p-type semiconductor heavily doped layer away from the n-type substrate, and
an n-type electrode layer arranged at a side of the n-type semiconductor heavily doped layer away from the n-type substrate and spaced apart from the n-type semiconductor doped layer;
wherein the active layer is arranged at a side of the n-type semiconductor doped layer away from the n-type substrate;
the n-type semiconductor heavily doped layer is configured as the second dielectric layer;
the n-type semiconductor doped layer is configured as the photonic crystal part and the first dielectric layer.

14. A preparing method of a photonic crystal laser, comprising:
providing a base substrate;
forming a first type semiconductor doped layer film on the base substrate;
applying a resist on the first type semiconductor doped layer film and pre-curing the resist to form a resist layer;
nanoimprinting the resist layer with an imprint template to transfer a pattern of the imprint template to the resist layer, and curing the resist layer to form a resist layer pattern;
patterning the first type semiconductor doped layer film with the resist layer pattern as a mask to form a photonic crystal layer, and removing the resist layer pattern; wherein,
the photonic crystal layer comprises a photonic crystal part, the photonic crystal part comprises a plurality of through holes arranged in an array, and the photonic crystal part comprises a central region and a peripheral region surrounding the central region, and the plurality of through holes comprise first through holes arranged in an array in the central region and second through holes arranged in an array in the peripheral region; a relative arrangement density of the first through holes is different from a relative arrangement density of the second through holes, and in a same direction, a variance of first distances between any two adjacent ones of the first through holes ranges from 1 nm² to 100 nm².

15. The preparing method according to claim 14, further comprising:
forming an active layer film on the base substrate;
forming a first dielectric layer film between the active layer film and the photonic crystal layer; wherein,
the active layer film is configured to emit light and serve as an optical gain medium.

16. The preparing method according to claim 15, further comprising: forming a second dielectric layer film at a side of the photonic crystal layer away from the first dielectric layer film, wherein a material of the second dielectric layer film is a first type semiconductor heavily doped material, and each of the through holes comprises a first end and a second end which are opposite along an extending direction of a channel thereof, the first end is connected with the first dielectric layer film, and the second end is connected with the second dielectric layer film.

17. The preparing method according to claim 16, further comprising forming a second type semiconductor doped layer film on the base substrate, wherein the second type semiconductor doped layer film and the active layer film are arranged on a same surface of the base substrate with the photonic crystal layer, and the active layer film is sandwiched between the photonic crystal layer and the second type semiconductor doped layer film.

18. The preparing method according to claim 17, further comprising forming a second type semiconductor heavily doped layer film on a side of the second type semiconductor doped layer film away from the active layer film.

19. The preparing method according to claim 18, wherein the first type semiconductor doped layer film is a p-type semiconductor doped layer film, and the second type semiconductor doped layer film is an n-type semiconductor doped layer film; in a process of patterning the first type semiconductor doped layer film with the resist layer pattern as a mask to form the photonic crystal layer, the first dielectric layer film is further formed at a side of the photonic crystal layer close to the base substrate, and the photonic crystal layer and the first dielectric layer film are of an integrated structure.

20. The preparing method according to claim 19, further comprising: forming a hard mask at a side of the second dielectric film away from the base substrate, forming a photoresist layer at a side of the hard mask away from the base substrate, patterning the photoresist layer to form a photoresist pattern covering a preset region, patterning the hard mask with the photoresist pattern as a mask and removing the photoresist pattern to form a hard mask pattern, patterning the second dielectric layer film, the photonic crystal layer, the first dielectric layer film, the active layer film and the second type semiconductor doped layer film with the hard mask pattern as a mask to form the second dielectric layer, the photonic crystal part, the first dielectric layer, the active layer and the second type semiconductor doped layer respectively, and an edge of an orthographic projection of the second type semiconductor doped layer on the base substrate and an edge of an orthographic projection of the second type semiconductor heavily doped layer film on the base substrate have a gap therebetween.

21. The preparing method according to claim 20, further comprising: removing the hard mask pattern, forming a p-type electrode layer at a side of the second dielectric layer away from the base substrate, and forming an n-type electrode layer at a side of the second type semiconductor heavily doped layer film away from the base substrate in the gap.

22. The preparing method according to any one of claims 18-21, wherein the first type semiconductor doped layer film is an n-type semiconductor doped layer film, and the second type semiconductor doped layer film is a p-type semiconductor doped layer film, the preparing method further comprises:
forming a hard mask at a side of the second type semiconductor heavily doped layer film away from the base substrate, forming a photoresist layer at a side of the hard mask away from the base substrate, patterning the photoresist layer to form a photoresist pattern covering a preset region, patterning the hard mask with the photoresist pattern as a mask and removing the photoresist pattern to form a hard mask pattern, patterning the second type semiconductor heavily doped layer film, the second type semiconductor doped layer film, the active layer film, the first dielectric layer film and the photonic crystal layer film with the hard mask pattern as a mask to form the second type semiconductor heavily doped layer, the second type semiconductor doped layer, the active layer, the first dielectric layer and the photonic crystal part respectively, and an edge of an orthographic projection of the photonic crystal part on the base substrate and an edge of an orthographic projection of the second type semiconductor heavily doped layer film on the base substrate have a gap therebetween.

23. The preparing method according to claim 22, further comprising: removing the hard mask pattern, forming a p-type electrode layer at a side of the second type semiconductor heavily doped layer away from the base substrate, and forming an n-type electrode layer at a side of the second type semiconductor heavily doped layer film away from the base substrate in the gap.
